(19) Europäisches Patentamt
European Patent Office
Office européen des brevets

(11) EP 1 340 327 B1

(12) EUROPEAN PATENT SPECIFICATION

(45) Date of publication and mention of the grant of the patent:
**01.06.2005 Bulletin 2005/22**

(21) Application number: **01989576.2**

(22) Date of filing: **23.11.2001**

(51) Int Cl.$^7$: **H04B 17/00**

(86) International application number:
**PCT/EP2001/014282**

(87) International publication number:
**WO 2002/043287 (30.05.2002 Gazette 2002/22)**

# (54) COMPONENT MEASURES

KOMPONENTENMESSUNG

MESURES SUR UN COMPOSANT

(84) Designated Contracting States:
**DE ES FR GB**

(30) Priority: **24.11.2000 GB 0028728**
**29.06.2001 GB 0116003**

(43) Date of publication of application:
**03.09.2003 Bulletin 2003/36**

(73) Proprietor: **Nokia Corporation**
**02150 Espoo (FI)**

(72) Inventor: **LOBO, Natividade, Albert**
**Windsor, Berkshire SL4 4BZ (GB)**

(74) Representative: **Haws, Helen**
**Nokia IPR Department,**
**Nokia House,**
**Summit Avenue**
**Farnborough, Hampshire GU14 0NG (GB)**

(56) References cited:
**WO-A-00/79708**
**WO-A-01/43299**
**US-A- 6 028 884**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 340 327 B1

## Description

The invention relates to measuring signal impairment as a result of individual components in spread spectrum systems.

In the past there has been a limited ability to determine the impact of a particular component on signal degradation for analog systems. Analog systems for the purpose of this application mean systems where all the information transmitted is held on a single analog pulse.

Filters in a communications device have a particular impact on the degradation of the output signal. In order to assess the impact a particular filter will have on signal degradation the manufacturer generally provides information on a filter of by way of a data sheet. The data sheet will typically specify the signal to noise ratio of the filter, the in-band ripple, the linearity of phase and the group delay time. The first two figures help a designer in deciding whether a particular filter is suitable for the application required and the linearity of phase and the group delay time allow characteristics of the filter to be factored in to the design of the device.

In spread spectrum systems, all the information transmitted is not retrievable from a single received pulse. For example in WCDMA each data element is modulated using a code comprising a string of positive and negative bits specific to an individual system user to create a set of data pulses. The entire set is transmitted. This allows the value of the data element to be retrieved if only a subset of the pulses transmitted is accurately received. The value of the bit is, however, calculated using all the received pulses both accurate and inaccurate rather than from an individual pulse as in analog systems.

The assessment data currently supplied for filters and other system components is useful in designing for analog systems where calculations are performed on individual pulses to determine the value of a transmitted data element. For spread spectrum systems, there is no equivalent test for components. To gain an idea of the degradation of the signal the whole system would be simulated and the final bit error rate measured.

In accordance with one aspect of the present invention there is provided a method of testing a signal processing component suitable for a device operating in a spread spectrum system in accordance with a predetermined modulation scheme, the method comprising: providing an input signal; generating a comparison output signal modulated in accordance with the predetermined modulation scheme from the input signal; generating a modified output signal modulated in accordance with the predetermined modulation scheme and modified such that the difference between the modified output signal and the comparison output signal is attributable to the signal processing operation performed by the device under test; correlating the modulated modified output signal operated on by the device under test with the modulated comparison output signal to provide a measure of the degradation on the signal of the component under test.

Embodiments of the invention are available that generate the modified signal and comparison signal at the same time. This allows the correlation to be run in real time. In alternative embodiments the comparison signal and the modified signal may be generated separately at different times, signals being stored and correlated subsequently.

The comparison signal is preferably the input signal modulated under the control of the ideal clock although other signals of known distortion could be used. For components that operate on a modulated signal such as filters and amplifiers, conveniently the modified signal is the modulated comparison signal subsequently operated on by the component under test. When the component under test is a filter the effectiveness of the filter is factored into the measure. This can be achieved by comparing the resulting correlation with the power throughput this provides additional information in the measure. Similar arrangements could be used to determine the effectiveness of other components that operate on the modulated signal.

When the component under test is used in generating the modulated signal, for example where the component is a timing element such as a clock, the modified signal is generated from an independent modulation of the input signal and the comparison made with an idealised version of the same component used during modulation. For example, if the component is a clock in embodiments of the invention the modified comparison signals are respectively generated by modulating the same input signal using a real and an ideal clock. To provide a measure at the end that is dimensionless, the correlation between the modified and comparison signals is compared with the self correlation of the comparison signal.

If the result of the correlation is an imaginary number the measure of the degradiation may be formed from the complex conjugate of the correlation.

According to another aspect of the invention there is provided means for testing a signal processing component suitable for a device operating in a spread spectrum system in accordance with a predetermined modulation scheme, the method comprising: means for providing an input signal; means for generating a comparison output signal modulated in accordance with the predetermined modulation scheme from the input signal; means for modifying the means for generating the comparison output signal such that the difference between the modified output signal and the comparison output signal is attributable to the signal processing operation performed by the component under test; means for generating the modified output signal in accordance with the predetermined modulation scheme; means for

correlating the modified output signal operated on by the device under test with the modulated comparison output signal to provide a measure of the degradation on the signal of the component under test.

In accordance with yet another aspect of the invention there is provided a method for testing a signal processing component suitable for a device operating in a spread spectrum system in accordance with a predetermined modulation scheme, the method comprising: providing an input signal; generating a comparison output signal modulated in accordance with the predetermined modulation scheme of known distortion from the input signal; generating an output signal modulated in accordance with the predetermined modulation scheme and operated on by the device under test from the input signal; correlating the modulated output signal operated on by the device under test with the modulated output signal of known distortion to provide a measure of the degradation on the signal of the component under test.

The step of generating an output signal of known distortion may comprise modulating the input signal under the control of a clock of known distortion, for example an ideal clock although other clocks could be used provided the distortion they introduce to the system is separately known.

In accordance with an embodiment of the invention, there is provided a data sheet for association with a component or set of similar components providing a correlation peak measure for a specified spread spectrum modulation scheme indicating the signal distortion attributable to the component operating on a signal modulated in accordance with the specified scheme.

The provision of a data sheet with individual components that include the measure including the correlation data, provides the designer with data not previously available allowing the intellegent selection of components for use in devices operating a particular modulation scheme. The data sheet may have a range of measures indicating the suitability of the component to a number of different modulation schemes.

The invention provides a versatile method and apparatus for testing and specifying system components so that the contribution of individual elements to signal degradation can be assessed. It leads to the creation of new units of measurement for individual components.

The invention will now be described in greater detail with reference to Figures 1 to 5 of the accompanying drawings of which:

Figure 1 is a schematic representation of a first embodiment of the invention for testing a filter;

Figure 2 is a schematic representation of a second embodiment of the invention for testing a filter; and

Figure 3 is a schematic representation of a third embodiment of the invention for testing a clock.

In spread spectrum systems such as WCDMA, GPS, TDD, unlike analog systems such as GSM, a single received pulse is not sufficient to decode the information in a message. Typically in spread spectrum systems each system user has a unique code comprising a string of 1 s and (-1s) for example {1, -1, 1, -1, -1, 1}. Each bit of the bit stream to be transmitted would then be spread using the unique code allocated to the user to create a number of pulses. When a pulse stream is received a correlation operation is performed in order to decode the received message. The higher the number of spread bits that are received correctly, the higher the correlation. The correlation is generally achieved by multiplying the received spread bits by the known unique code. If the bit has been correctly received the result will be a positive number. If not it will be negative. In spread spectrum systems, the number of errors received or the bit error rate provides an indication of the strength of the signal.

As stated in the introduction, in the past this has been the only measure that could be made. It was a matter for intuition or guesswork as to which of the components or elements of the system were causing the greatest degradation to the signal. Using the present invention each element of the system can be tested in isolation to determine its effect on the correlation between the transmitted and received signals. This will allow components to be selected that improve the bit error rate of the system.

In the first illustrated example, the element under test is a filter 10. Figure 1 shows a generator for generating test bits 1, a modulator 2 generating the pulses for transmission B(t) under the control of an ideal clock 3. The input signal is suitably a synchronisation frame. The modulation scheme selected for this element of the equipment can be changed so the characteristics of the filter in operation for a number of modulation schemes can be measured. The pulse stream generated is then passed through the filter under test 4. The output from the filter A(t) is then correlated with the unfiltered pulse stream

$$B(t). \quad c(t) = \int_t^{t+T} A[t_1]B*[t_1]dt_1$$

This operation could be completed in real time with two inputs A(t) and B(t) as illustrated in Figure 1. It could, however, be achieved by storing the filtered output and the unfiltered output on separate occasions and then performing a correlation.

A correlation operation 5 is used to assess the difference between the filtered and unfiltered data streams as this is similar to the operation used to decode the received data streams in operation. If the correlation between the two streams is poor, the bit error rate when a pulse stream using the tested filter is transmitted would be high. The correlation between filtered and unfiltered systems will be different for different modulation schemes. Not only because the frequency may alter but also because other factors may also effect the performance of the filter for a particular scheme. The correlation between the unfiltered and filtered signal will be termed for the purposes of this application the correlation peak.

This test on its own provides some information on the filter. However, a component that performed no filtering function may provide a very good correlation between the input signal and the output signal. A second test may then be conducted on a filter to show how effective a filter it is. Figure 2 shows a white noise generator being fed through a filter under test. By correlating the filtered output with itself, the power passing through the filter is measured. The higher the power the less effective the filter will be as it will be letting through a large window of frequencies. By dividing the correlation peak achieved from the apparatus of Figure 1 by the power measure of the apparatus of Figure 2, a measure of the effectiveness of the filter is achieved. If white noise with a unit power spectral density is used a normalized figure can be reproduced. The result of the test of Figure 1 could be high but if the result from figure 2 is also high the final measure would be low. Similarly, the correlation from figure 1 may be low but the power from the test of figure 2 could also be low providing the same result. A graph depicting a comparison of a real filter in a GPS receiver is illustrated in figure 4 by way of example only.

The suitability of a device for a particular modulation scheme can be determined by using that modulation scheme in the test apparatus of Figure 1. The data for each relevant modulation scheme can then be recorded and provided in association with the filter to enable designers to select a filter suitable for a particular system and modulation scheme.

A filter or set of filters may be supplied with a correlation peak to noise ratio for a single or range of modulation schemes tested. Designers can then select a filter suitable for one of a range of spread spectrum modulations schemes including WCDMA GPS and TDD. The correlation to noise peak ratio may be provided as a data sheet attached to number of filters delivered in bulk or to a single filter it could also be provided on a label attached to individual filters or on individual or bulk packages. In addition the values of the ratio may be held on a data base accessible to the designer associated with the name or label of the filter.

The fundamental method used to test filters and assign to them a value that indicates their performance for a particular modulation scheme can also be used to assess other signal processing components of the system. Another group of components operate under the control of a clock. These components affect the timing of the transmitted pulses and can therefore affect the correlation achieved when the transmitted signal is received.

Figure 3 shows a system that can be used to test a clock component. Test bits are generated 30 and fed to a modulator 32 operating under the control of an ideal clock 33. An output signal A(t) is generated. At the same or a separate time, the same generated test bits are fed to a modulator 32 operating under the control of a clock under test. An output signal B(t) is generated. A correlation operation

$$c(t) = \int_t^{t+T} A[t_1]B*[t_1]dt_1$$

is then performed on the modulated signal generated under control of an ideal clock and the modulation signal generated under control of the clock under test 35. This provides an indication of the degradation of the signal as a result of the clock under test. To provide a dimensionless quantity, a separate correlation operation is performed between the signal modulated by the ideal clock with itself 36. The output of the correlation with the clock under test is then divided with the self correlation output 37 to provide a value that indicates the amount of degradation on a signal for the particular modulation scheme tested attributable to the clock under test. A graph depicting a comparison of real clocks with Allen Variances of $10^{-8}$, $3.10^{-8}$ and $10^{-7}$ can be seen in figure 5 for illustrative purposes only.

The test apparatus described in relation to a clock can be adapted for use with components such as clocks, and to test automatic frequency control algorithms and synchronization algorithms. These components could be rated for use with a particular modulation scheme as could components incorporating the algorithms. Again the data indicating the degradation of the signal attibutable to individual components could be provided as a data sheet or other form of labelling attached to individual or multiple components. For each component the correlation between the comparison and modified signals is again termed the correlation peak.

More detail of the mathematics and example correlations for a GPS signal can be found in the annex attached

to priority application UK 0028728.4 incorporated herein, see the Annex.

In view of the foregoing description it will be evident to a person skilled in the art that various modifications may be made within the scope of the invention. In particular the skilled man will realise that embodiments in accordance with the present invention can be used to test a range of elements of the system including but not restricted to filters, amplifiers including low noise amplifiers, mixers and timing elements such as clocks, automatic frequency control algorithms and synchronization algorithms. For each component a correlation peak data for a particular modulation scheme will provide useful design information.

ANNEX

■ Correlation to Noise Concept

One of the most useful metrices for analog systems is the concept of Signal to Noise ratio. Filters in analog systems the signal to noise ratio. However, in spread sprectum systems, the concept is not so useful. The current tendency is to simulate the entire system and measure the final bit error rate (BER).

We propose a new measure the Correlation to noise Ratio to measure filters used in spread spectrum systems

Experiment 1

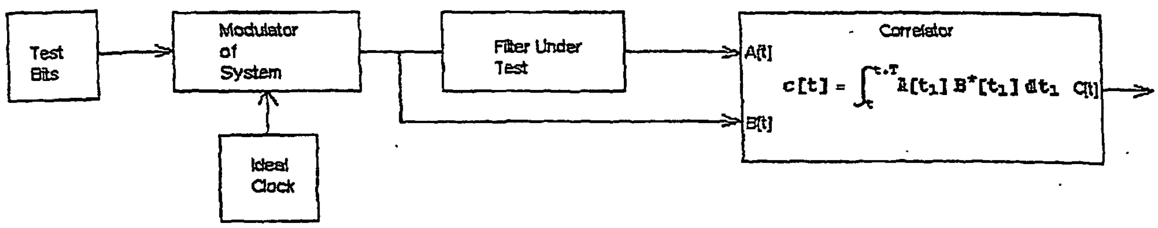


Experiment 2

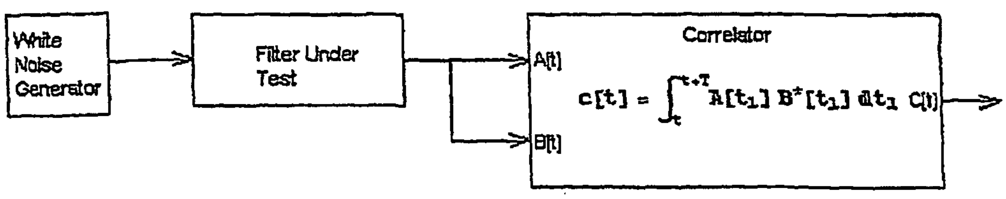


The correlation to noise ratio is the result of Experiment 1 divided by the result of Experiment 2 assuming the white noise generator has unit power spectral density. A GPS modulator would be used to test the effect of the filter in a GPS system. Similarly, a WCDMA modulator would be used to measure the performance of the filter in a WCDMA system. The test bits could be any bits. It is useful to use the synchronisation frame.

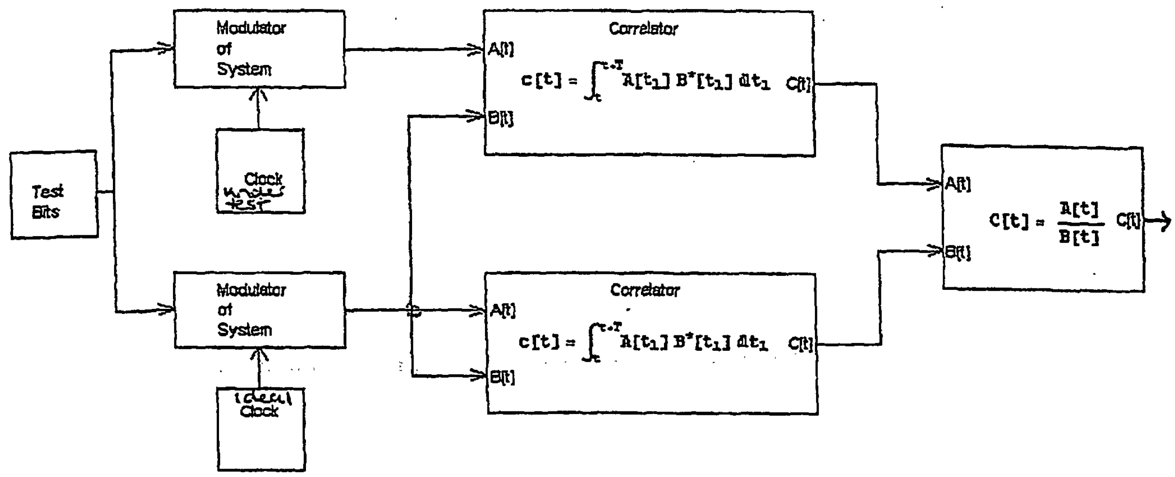


For clocks we propose a dimensionless quantity that measures the degradation due to the clock imperfections when used in the system e.g. GPS, WCDMA

Clear[T]

$$c[t] = \int_t^{t+T} A[t_1]\, B^*[t_1]\, dt_1$$

$$\int_t^{t+T} A[t_1]\, B^*[t_1]\, dt_1$$

We consider the clock frequency of the receiver to be in error

$$f_r = f0 + \delta f$$

We can express this as

$$f_r = f0\left(1 + \frac{\delta f}{f0}\right)$$

We assume that the frequency has been measured over a period of time of 50ms.
Let the ideal bit period be represented by T
Let the ith bit period be represented by T[i] where

$$T[i] = T\,(1 - \chi[i])$$

where $\chi[i]$ is a random variable representing the Allen variance of the clock
Thus we get the relation for time at the ith bit period to be

$$t_r = t\,(1 - \chi[i])$$

InverseFourierTransform[DiracDelta[f], f, t, FourierParameters → {0, -2π}]
1
FourierTransform[Sin[t], t, f, FourierParameters → {0, -2π}]
-iπDiracDelta[-1 + 2 f π ] + i π DiracDelta[1 + 2fπ]

FourierTransform[Sin[2πf0 (α[i]t - β[i-1]T)],
t, f, FourierParameters → {0, -2π}]
0

$$\text{InverseFourierTransform}[\frac{e^{i\alpha f}}{f-\beta}, f, t, \text{FourierParameters} \to \{0, -2\pi\}]$$

$$i\, e^{i\,(2\pi t+\alpha)\,\beta}\, \pi\, \text{Sign}[2\pi t+\alpha]$$

$$\text{InverseFourierTransform}[\frac{e^{-2 i \pi f1}}{f1}, f1, t, \text{FourierParameters} \to \{0, -2\pi\}]$$

$$-i\,\pi\,\text{Sign}[1-t]$$

$$\text{InverseFourierTransform}[\frac{1}{f1}, f1, t, \text{FourierParameters} \to \{0, -2\pi\}]$$

$$-i\,\pi\,\text{Sign}[t]$$

The ideal BPSK signal generated

$$\sum_{i=0}^{NN-1} ca[i]\ (\text{UnitStep}[t - i\,T] - \text{UnitStep}[t - (i+1)\,T])\ \text{Sin}[2\pi f0\ (t - i\,T)]$$

The received signal becomes when the value of t from the above equation

$$\sum_{i=0}^{NN-1} ca[i]\ (\text{UnitStep}[t\,\alpha[i] - \beta[i-1]\,T] - \text{UnitStep}[t\,\alpha[i] - \beta[i]\,T])\ \text{Sin}[2\pi f0\ (t\,\alpha[i] - \beta[i-1]\,T)]$$

with α[i]=(1-χ[i]).

$$\beta[-1] := 0$$

$$\beta[i_]\ /;\ i \neq -1 := \sum_{j=0}^{i} \alpha[j]$$

$$\text{FourierTransform}[\text{UnitStep}[t], t, f, \text{FourierParameters} \to \{0, -2\pi\}]$$

$$-\frac{i}{2 f \pi} - \frac{\text{DiracDelta}[f]}{2}$$

$$\text{UnitStep}[t] \Leftrightarrow -\frac{i}{2 f \pi} - \frac{\text{DiracDelta}[f]}{2}$$

$$\text{UnitStep}[\alpha[i]\ t] \Leftrightarrow -\frac{i}{2 f \pi} - \frac{\text{DiracDelta}\left[\frac{f}{\alpha[i]}\right]}{2\,\alpha[i]}$$

$$\text{UnitStep}[t\,\alpha[i] - \beta[i-1]\,T] \Leftrightarrow e^{i\,2\pi \frac{f}{\alpha[i]} \beta[i-1]\,T} \left(-\frac{i}{2 f \pi} - \frac{\text{DiracDelta}\left[\frac{f}{\alpha[i]}\right]}{2\,\alpha[i]}\right)$$

$$\text{UnitStep}[t\,\alpha[i] - \beta[i]\,T] \Leftrightarrow e^{i\,2\pi \frac{f}{\alpha[i]} \beta[i]\,T} \left(-\frac{i}{2 f \pi} - \frac{\text{DiracDelta}\left[\frac{f}{\alpha[i]}\right]}{2\,\alpha[i]}\right)$$

The spectrum of sin [x] is

$$\text{Sin}[t] \Leftrightarrow -i\,\pi\,\text{DiracDelta}[-1 + 2 f \pi] + i\,\pi\,\text{DiracDelta}[1 + 2 f \pi]$$

Thus the spectrum of Sin[2π f0 (t α[i] - β[i-1]T)]

$$\text{Sin}[\gamma t + \rho] \Leftrightarrow \left(\frac{1}{\gamma} e^{i \frac{2\pi\rho f}{\gamma}} \left(-i\,\pi\,\text{DiracDelta}\left[-1 + 2 \frac{f}{\gamma} \pi\right] + i\,\pi\,\text{DiracDelta}\left[1 + 2 \frac{f}{\gamma} \pi\right]\right)\right)$$

$$\begin{aligned}&\text{Sin}[2\pi\,f0\,(t\,\alpha[i] - \beta[i-1]\,T)] \Leftrightarrow \\ &\quad \left(\frac{1}{\gamma} e^{i \frac{2\pi\rho f}{\gamma}} \left(-i\,\pi\,\text{DiracDelta}\left[-1 + 2 \frac{f}{\gamma} \pi\right] + i\,\pi\,\text{DiracDelta}\left[1 + 2 \frac{f}{\gamma} \pi\right]\right)\right) /. \\ &\quad \{\gamma \to 2\pi\,f0\,\alpha[i],\ \rho \to 2\pi\,f0\,\beta[i-1]\,T\}\end{aligned}$$

$$\begin{aligned}&\left(\frac{1}{\gamma} e^{i \frac{2\pi\rho f}{\gamma}} \left(-i\,\pi\,\text{DiracDelta}\left[-1 + 2 \frac{f}{\gamma} \pi\right] + i\,\pi\,\text{DiracDelta}\left[1 + 2 \frac{f}{\gamma} \pi\right]\right)\right) /. \\ &\quad \{\gamma \to 2\pi\,f0\,\alpha[i],\ \rho \to 2\pi\,f0\,\beta[i-1]\,T\}\end{aligned}$$

$$\frac{e^{\frac{2 i f \pi T \beta[-1+i]}{\alpha[i]}} \left(-i\,\pi\,\text{DiracDelta}\left[-1 + \frac{f}{f0\,\alpha[i]}\right] + i\,\pi\,\text{DiracDelta}\left[1 + \frac{f}{f0\,\alpha[i]}\right]\right)}{2\,f0\,\pi\,\alpha[i]}$$

$$\begin{aligned}&\text{Sin}[2\pi\,f0\,(t\,\alpha[i] - \beta[i-1]\,T)] \Leftrightarrow 0.5\,e^{\frac{2 i f \pi T \beta[-1+i]}{\alpha[i]}} \\ &\quad (-i\ \text{DiracDelta}[-f0\,\alpha[i] + f] + i\ \text{DiracDelta}[f0\,\alpha[i] + f])\end{aligned}$$

Thus we have the fourier transform

$$\sum_{i=0}^{NN-1} ca[i]\ (\text{UnitStep}[t\,\alpha[i]\ - \beta[i-1]\ T] - \text{UnitStep}[t\,\alpha[i]\ - \beta[i]\ T])$$
$$\text{Sin}[2\,\pi\,f0\ (t\,\alpha[i] - \beta[i-1]\ T)]\Leftrightarrow$$
$$\sum_{i=0}^{NN-1} ca[i]\ \left(\left(e^{i\,2\,\pi\,\frac{f}{\alpha[i]}\,\beta[i-1]\,T}\left(-\frac{i}{2\,f\,\pi}-\frac{\text{DiracDelta}\left[\frac{f}{\alpha[i]}\right]}{2\,\alpha[i]}\right)-\right.\right.$$
$$\left.e^{i\,2\,\pi\,\frac{f}{\alpha[i]}\,\beta[i]\,T}\left(-\frac{i}{2\,f\,\pi}-\frac{\text{DiracDelta}\left[\frac{f}{\alpha[i]}\right]}{2\,\alpha[i]}\right)\right) *$$
$$\left.\left(0.5\,e^{\frac{2\,i\,f\,\pi\,T\,\beta[-1+i]}{\alpha[i]}}\ (-i\ \text{DiracDelta}[-f0\,\alpha[i]+f]+i\ \text{DiracDelta}[f0\,\alpha[i]+f])\right)\right)$$

Simplifying the first component

$$\text{FirstTerm} = \left(e^{i\,2\,\pi\,\frac{f}{\alpha[i]}\,\beta[i-1]\,T}\left(-\frac{i}{2\,f\,\pi}-\frac{\text{DiracDelta}\left[\frac{f}{\alpha[i]}\right]}{2\,\alpha[i]}\right)-\right.$$
$$\left.e^{i\,2\,\pi\,\frac{f}{\alpha[i]}\,\beta[i]\,T}\left(-\frac{i}{2\,f\,\pi}-\frac{\text{DiracDelta}\left[\frac{f}{\alpha[i]}\right]}{2\,\alpha[i]}\right)\right)\ //\ \text{Expand}$$
$$-\frac{i\,e^{\frac{2\,i\,f\,\pi\,T\,\beta[-1+i]}{\alpha[i]}}}{2\,f\,\pi}+\frac{i\,e^{\frac{2\,i\,f\,\pi\,T\,\beta[i]}{\alpha[i]}}}{2\,f\,\pi}-$$
$$\frac{e^{\frac{2\,i\,f\,\pi\,T\,\beta[-1+i]}{\alpha[i]}}\ \text{DiracDelta}\left[\frac{f}{\alpha[i]}\right]}{2\,\alpha[i]}+\frac{e^{\frac{2\,i\,f\,\pi\,T\,\beta[i]}{\alpha[i]}}\ \text{DiracDelta}\left[\frac{f}{\alpha[i]}\right]}{2\,\alpha[i]}$$

Simplifying the second component

$$\text{SecondTerm} =$$
$$\left(0.5\,e^{\frac{2\,i\,f\,\pi\,T\,\beta[-1+i]}{\alpha[i]}}\ (-i\ \text{DiracDelta}[-f0\,\alpha[i]+f]+i\ \text{DiracDelta}[f0\,\alpha[i]+f])\right)\ //\ \text{Expand}$$
$$-0.5\,i\,e^{\frac{2\,i\,f\,\pi\,T\,\beta[-1+i]}{\alpha[i]}}\ \text{DiracDelta}[f-f0\,\alpha[i]]+0.5\,i\,e^{\frac{2\,i\,f\,\pi\,T\,\beta[-1+i]}{\alpha[i]}}\ \text{DiracDelta}[f+f0\,\alpha[i]]$$

$$\sum_{i=0}^{NN-1} ca[i]\ (\text{UnitStep}[t\,\alpha[i]\ - \beta[i-1]\ T] - \text{UnitStep}[t\,\alpha[i]\ - \beta[i]\ T])$$
$$\text{Sin}[2\,\pi\,f0\ (t\,\alpha[i] - \beta[i-1]\ T)]$$
$$\Leftrightarrow$$
$$\sum_{i=0}^{NN-1} ca[i]\ \text{Convolve}[\text{FirstTerm},\ \text{SecondTerm},\ f]$$

Where we have defined convolve

```
Clear[Convolve]

Convolve[f1_ + f2_, g_, t_] := Convolve[f1, g, t] + Convolve[ f2, g, t]

Convolve[f_, g1_ + g2_, t_] := Convolve[f, g1, t] + Convolve[ f, g2, t]

Convolve[f_, g_, t_] /; FreeQ[f, DiracDelta] && FreeQ[g, DiracDelta] :=
 Integrate[(f /. t → τ) (g /. t → t - τ), {τ, -Infinity, Infinity}]

Convolve[f_, g_, t_] /; Not[FreeQ[f, DiracDelta]] && FreeQ[g, DiracDelta] :=
  Convolve[g, f, t];
```

```
Convolve[f_, g_, t_] /; Not[FreeQ[g, DiracDelta]] :=
 Module[{x1, x2, x3, x4, x5, x6, x7, x8, x9, x10, τ},
  x1 = Position[g, DiracDelta[x_]];
  x2 = Extract[g, x1][[1]];
  x3 = ReplacePart[g, 1, x1];
  x4 = (f /. t → (t - τ)) (x3 /. t → τ);
  x5 = x2[[1]];
  x6 = x5 /. t → 0;
  x7 = (x5 - x6) // Simplify // (# /. t → 1) &;
  x8 = Solve[x5 == 0, t];
  x9 = τ → (t /. x8)[[1]];
  Abs[1/x7] (x4 /. x9)]
```

$$\text{Convolve}\left[-\frac{1}{2\,\alpha[i]}\left(i\,e^{\frac{2\,i\,f\,i\,\pi\,T\,\beta[-1+i]}{\alpha[i]}}\,\pi\,\text{DiracDelta}\left[\pi\left(-f0+\frac{f}{\alpha[i]}\right)\right]\right),\; e^{\frac{2\,i\,i\,\pi\,T\,(f0\,\alpha[i]\,(2\,\beta[-1+i]-\beta[i])+f\,\beta[i])}{\alpha[i]}},\, f\right]$$

$$-\frac{1}{2\,\alpha[i]}\left(i\,e\verb|^|\left(2\,i\,f0\,i\,\pi\,T\,\beta[-1+i]+\frac{1}{\alpha[i]}\,(2\,i\,i\,\pi\,T\,(f0\,\alpha[i]\,(2\,\beta[-1+i]-\beta[i])+(f-f0\,\alpha[i])\,\beta[i]))\right)\text{Abs}[\alpha[i]]\right)$$

$$\sum_{i=0}^{NN-1}\text{ca}[i]\ \text{Convolve}[\text{FirstTerm},\ \text{SecondTerm},\ f]$$

$$\sum_{i=0}^{NN-1}\text{ca}[i]\ \text{Convolve}[\text{FirstTerm},\ \text{SecondTerm},\ f]$$

```
(AllTerms = Convolve[FirstTerm, SecondTerm, f] // Simplify) //
 (# /. {Abs[α[i]] → α[i]}) &
```

$$\frac{0.25\,i\,e^{\frac{2\,i\,f\,\pi\,T\,\beta[-1+i]}{\alpha[i]}}\,\text{DiracDelta}\left[-f0+\frac{f}{\alpha[i]}\right]}{\alpha[i]}-\frac{0.25\,i\,e^{\frac{2\,i\,\pi\,T\,(f0\,\alpha[i]\,(\beta[-1+i]-\beta[i])+f\,\beta[i])}{\alpha[i]}}\,\text{DiracDelta}\left[-f0+\frac{f}{\alpha[i]}\right]}{\alpha[i]}-$$

$$\frac{0.25\,i\,e^{\frac{2\,i\,f\,\pi\,T\,\beta[-1+i]}{\alpha[i]}}\,\text{DiracDelta}\left[f0+\frac{f}{\alpha[i]}\right]}{\alpha[i]}+\frac{0.25\,i\,e^{\frac{2\,i\,\pi\,T\,(f\,\beta[i]+f0\,\alpha[i]\,(-\beta[-1+i]+\beta[i]))}{\alpha[i]}}\,\text{DiracDelta}\left[f0+\frac{f}{\alpha[i]}\right]}{\alpha[i]}+$$

$$e^{-2\,i\,f0\,\pi\,T\,\beta[-1+i]}\left(\frac{0.0795775\,e^{\frac{2\,i\,\pi\,T\,(f0\,\alpha[i]\,(2\,\beta[-1+i]-\beta[i])+f\,\beta[i])}{\alpha[i]}}}{f-f0\,\alpha[i]}-\frac{0.0795775\,e^{\frac{2\,i\,\pi\,T\,(f+f0\,\alpha[i])\,\beta[i]}{\alpha[i]}}}{f+f0\,\alpha[i]}+\frac{0.159155\,e^{\frac{2\,i\,\pi\,T\,(f+f0\,\alpha[i])\,\beta[-1+i]}{\alpha[i]}}\,f0\,\alpha[i]}{-f^2+f0^2\,\alpha[i]^2}\right)$$

```
FinalValTest = Table[CorrTest[τ], Evaluate[{τ, -T, T, T/20} /. GPSSystem]];
```

```
SpectrumCACode[m_, CACode_, f_] := Module[{x1, x2, x3, x4, x5, Sinc},
  GPSSystem = {T → 1/(1.023 10^6), f0 → 1575.42 10^6};
  Sinc[0.0] := 1;
  Sinc[x_] := Sin[x]/x;
  x1 = Table[CACode, {i, 1, m}] // Apply[Join, #] &;
```

$$x2 = \sum_{i=0}^{\mathrm{Length}[x1]-1}\left(x1[[i+1]]\,\frac{0.25`\,i\,e^{\frac{2 i f \pi T \beta[-1+i]}{\alpha[i]}}\,\mathrm{DiracDelta}\left[-f0+\frac{f}{\alpha[i]}\right]}{\alpha[i]} - \frac{0.25`\,i\,e^{\frac{2 i \pi T (f0\,\alpha[i]\,(\beta[-1+i]-\beta[i])+f\,\beta[i])}{\alpha[i]}}\,\mathrm{DiracDelta}\left[-f0+\frac{f}{\alpha[i]}\right]}{\alpha[i]} - \frac{0.25`\,i\,e^{\frac{2 i f \pi T \beta[-1+i]}{\alpha[i]}}\,\mathrm{DiracDelta}\left[f0+\frac{f}{\alpha[i]}\right]}{\alpha[i]} + \frac{0.25`\,i\,e^{\frac{2 i \pi T (f\,\beta[i]+f0\,\alpha[i]\,(-\beta[-1+i]+\beta[i]))}{\alpha[i]}}\,\mathrm{DiracDelta}\left[f0+\frac{f}{\alpha[i]}\right]}{\alpha[i]} + e^{-2 i f0 \pi T \beta[-1+i]}\left(\frac{0.0795774715459476 7`\,e^{\frac{2 i \pi T (f0\,\alpha[i]\,(2\beta[-1+i]-\beta[i])+f\,\beta[i])}{\alpha[i]}}}{f-f0\,\alpha[i]} - \frac{0.07957747154594767`\,e^{\frac{2 i \pi T (f+f0\,\alpha[i])\,\beta[i]}{\alpha[i]}}}{f+f0\,\alpha[i]} + \frac{0.15915494309189535`\,e^{\frac{2 i \pi T (f+f0\,\alpha[i])\,\beta[-1+i]}{\alpha[i]}}\,f0\,\alpha[i]}{-f^2+f0^2\,\alpha[i]^2}\right)\right) \;/.\; \mathrm{GPSSystem}];$$

```
General::spell :
 Possible spelling error: new symbol name "Sinc" is similar to existing symbols {Sin, Sinh}.

<< Statistics`ContinuousDistributions`

Clear[α1, β1]

AllanRandom = RandomArray[NormalDistribution[0, 10^-8], 1023 2 + 1];
```

The generation of C/A code generator. We intend to calculate the sequence once and forall

```
G1Register = Table[1, {i, 1, 10}];

UpdateG1Register :=
 Module[{x1, x2},
  x1 = G1Register;
  x2 = Mod[x1[[3]] + x1[[10]], 2];
  G1Register = Join[{x2}, Drop[x1, -1]]; Last[x1]]

CACode = Table[UpdateG1Register, {i, 1, 2^10 - 1 }] // 2 # - 1 &;
```

```
FunSpectrum[f1_] = SpectrumCACode[2, CACode, f1];

α1[i_] := (1 - AllenRandom[[i + 1]])

α1[5]

Part::partd : Part specification AllenRandom[[6]] is longer than depth of object.

1 - AllenRandom[[6]]

α2[i_] := 1

β2[i_] := i + 1

General::spell1 : Possible spelling error: new symbol name "β2" is similar to existing symbol "α2".

Clear[IdealSpec]

IdealSpec[f1_] = FunSpectrum[f1] /. {α → α2, β → β2};
```

GPSSystem = $\left\{T \to \frac{1}{1.023\ 10^6}, f0 \to 1575.42\ 10^6\right\}$;

$\frac{16}{T}$ /. GPSSystem

$1.6368 \times 10^7$

δf = $\left(\frac{16}{T}\text{ /. GPSSystem}\right) / 256$

63937.5

We will be working with approximately 4 kHz

IdealFreqPos = Table[IdealSpec[f],
Evaluate[{f, $\left(-\frac{16}{2\,T} + f0\text{ /. GPSSystem}\right) + \frac{\delta f}{2}, \left(\frac{16}{2\,T} + f0\right)$ /. GPSSystem, δf}]];

ListPlot[20 Log[10, Abs[IdealFreqPos]], PlotJoined → True, PlotRange → All]

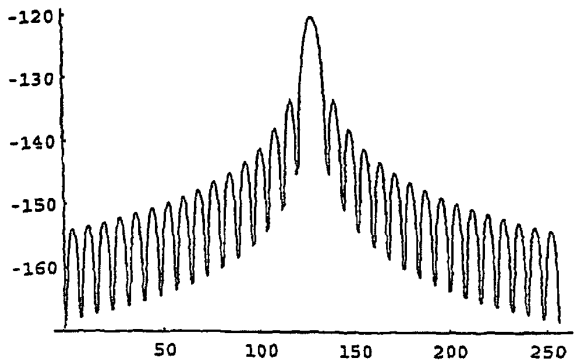


- Graphics -

We will be working with approximately 4 kHz

```
IdealFreqPos = Table[IdealSpec[f],
   Evaluate[{f, (-16/(2 T) + f0 /. GPSSystem) + δf/2, (16/(2 T) + f0) /. GPSSystem, δf}]];
ListPlot[20 Log[10, Abs[IdealFreqPos]], PlotJoined → True, PlotRange → All]
```

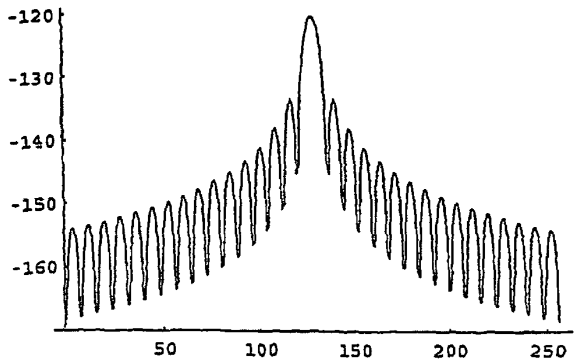


- Graphics -

```
spec = {Table[f, Evaluate[{f, (- 16/(2 Tc) /. GPSSystem) + δf/2, 16/(2 Tc) /. GPSSystem, δf}]],
    20 Log[10, Abs[freqtab]] } // Transpose;

ListPlot[spec // Map[{#[[1]] 10^-6, #[[2]]} &, #] &, PlotJoined → True, PlotLabel →
  StyleForm[StringJoin["Fourier transform of the C/A Code\n Center freq = ",
    ToString[(f0 /. GPSSystem) 10^-9], "GHz\n\n"],
   FontFamily → "Arial", FontWeight → "Bold"], AxesLabel → {"MHz", "dB"} ]

IdealFreq = Module[{x1, x2, x3},
   x1 = Table[IdealSpec[f],
     Evaluate[{f, (- 16/(2 T) - f0 /. GPSSystem) + δf/2, (16/(2 T) - f0) /. GPSSystem, δf}]];
   x2 = Table[IdealSpec[f], Evaluate[{f, (- 16/(2 T) + f0 /. GPSSystem) + δf/2,
       (16/(2 T) + f0) /. GPSSystem, δf}]];
   Join[
    x1,
    x2]];

(x1 = {Table[f 10^-6,
      Evaluate[{f, (- 16/(2 T) + f0 /. GPSSystem) + δf/2, (16/(2 T) + f0) /. GPSSystem, δf}]],
     20 Log[10, Abs[Drop[IdealFreq, Length[IdealFreq]/2]]]} //
   Transpose) // ListPlot[#, PlotJoined → True] &
```

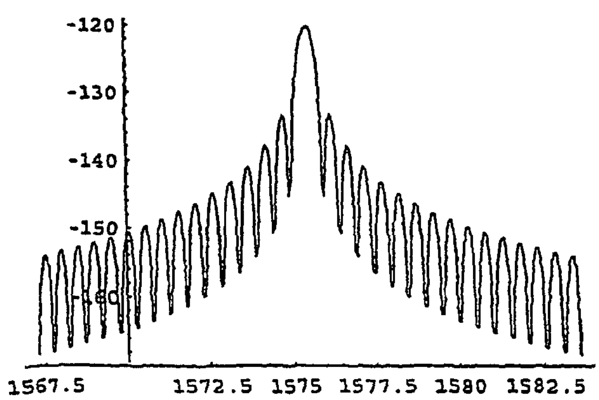


- Graphics -

```
gra7 = ListPlot[x1, PlotLabel →
   StyleForm[StringJoin["\n\n Ideal Spectrum of the GPS signal \n\n\n"],
     FontFamily → "Arial", FontSize → "24", FontWeight → "Bold"],
  PlotJoined → True, AxesLabel → {StyleForm["Freq(MHz)", FontFamily → "Arial",
     FontSize → "24", FontWeight → "Bold"], StyleForm["Spec(dB)",
     FontFamily → "Arial", FontSize → "24", FontWeight → "Bold"]},
  AxesOrigin → {1575.42, -160}, GridLines → Automatic]
```

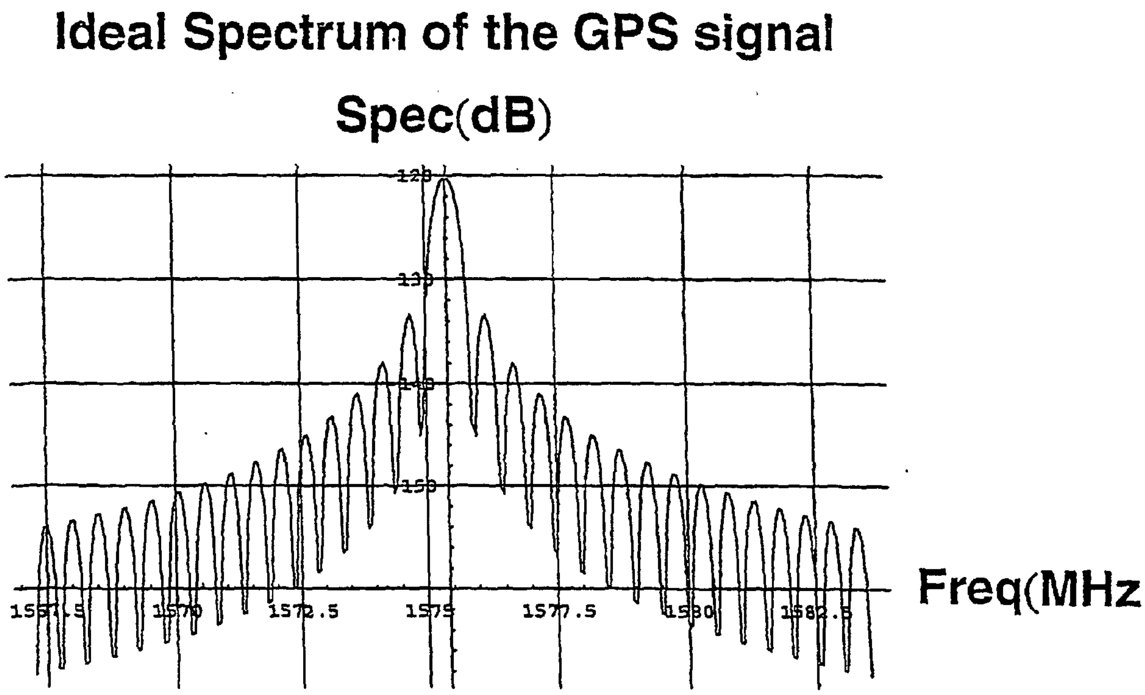


```
- Graphics -

Save["IdealFreqVal.m", IdealFreq]

DelayVec[τ_] := Module[{x1, x2, x3},
   x1 = Table[e^(i 2 π f τ),
     Evaluate[{f, (-16/(2 T) - f0 /. GPSSystem) + δf/2, (16/(2 T) - f0) /. GPSSystem, δf}]];
   x2 = Table[e^(i 2 π f τ), Evaluate[{f, (-16/(2 T) + f0 /. GPSSystem) + δf/2,
       (16/(2 T) + f0) /. GPSSystem, δf}]];
   Join[
    x1,
    x2]];
```

```
GenAllenVariance[n_] := Module[{x1, x2, x3},
  AllenRandom = RandomArray[NormalDistribution[0, n], 1023 2 + 1];
  Clear[β1];
  β1[-1] := 0;
  β1[i_] /; i ≠ -1 := β1[i] = β1[i - 1] + α1[i];
  Table[β1[i], {i, 0, 2 1023 }];]

General::spell1 :
 Possible spelling error: new symbol name "AllenRandom" is similar to existing symbol "AllanRandom".

Clear[ReceivedSpec]

ReceivedSpec[allenvar_] :=
 Module[{x1, x2, x3, x4},
  GenAllenVariance[allenvar];
  Clear[NormalSpec];
  NormalSpec[f1_] = FunSpectrum[f1] /. {α → α1, β → β1};
  x1 = Table[NormalSpec[f],
    Evaluate[{f, (-16/(2 T) - f0 /. GPSSystem) + δf/2, (16/(2 T) - f0) /. GPSSystem, δf}]];
  x2 = Table[NormalSpec[f], Evaluate[
     {f, (-16/(2 T) + f0 /. GPSSystem) + δf/2, (16/(2 T) + f0) /. GPSSystem, δf}]];
  Join[
   x1,
   x2]]

ReceivedSpec1 = ReceivedSpec[10^-8];

ListPlot[20 Log[10, Abs[ReceivedSpec1]], PlotJoined → True, PlotRange → All]
```

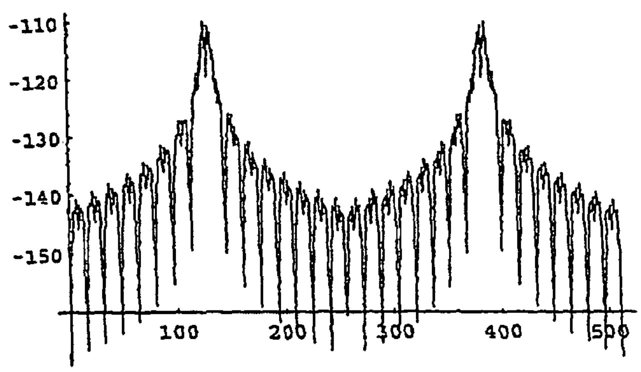


- Graphics -

```
(x1 = {Table[f 10^-6,
    Evaluate[{f, (-16/(2 T) + f0 /. GPSSystem) + δf/2, (16/(2 T) + f0) /. GPSSystem, δf}]],
   20 Log[10, Abs[Drop[ReceivedSpec1, Length[ReceivedSpec1]/2]]]} //
   Transpose) // ListPlot[#, PlotJoined → True] &
```

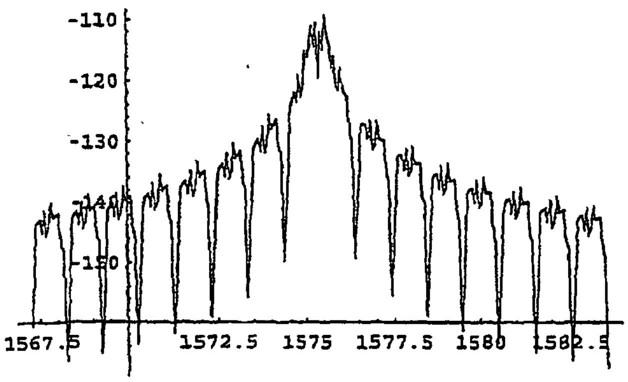


- Graphics -

```
gra7 = ListPlot[x1, PlotLabel →
   StyleForm[StringJoin["\n\n Spectrum of the correlating  signal \n generated
       by a  GPS receiver with a clock\n with Allen Variance of 10^-8 \n\n\n"],
     FontFamily → "Arial", FontSize → "24", FontWeight → "Bold"],
  PlotJoined → True, AxesLabel → {StyleForm["Freq(MHz)", FontFamily → "Arial",
     FontSize → "24", FontWeight → "Bold"], StyleForm["Spec(dB)",
     FontFamily → "Arial", FontSize → "24", FontWeight → "Bold"]},
  AxesOrigin → {1575.42, -160}, GridLines → Automatic]
```

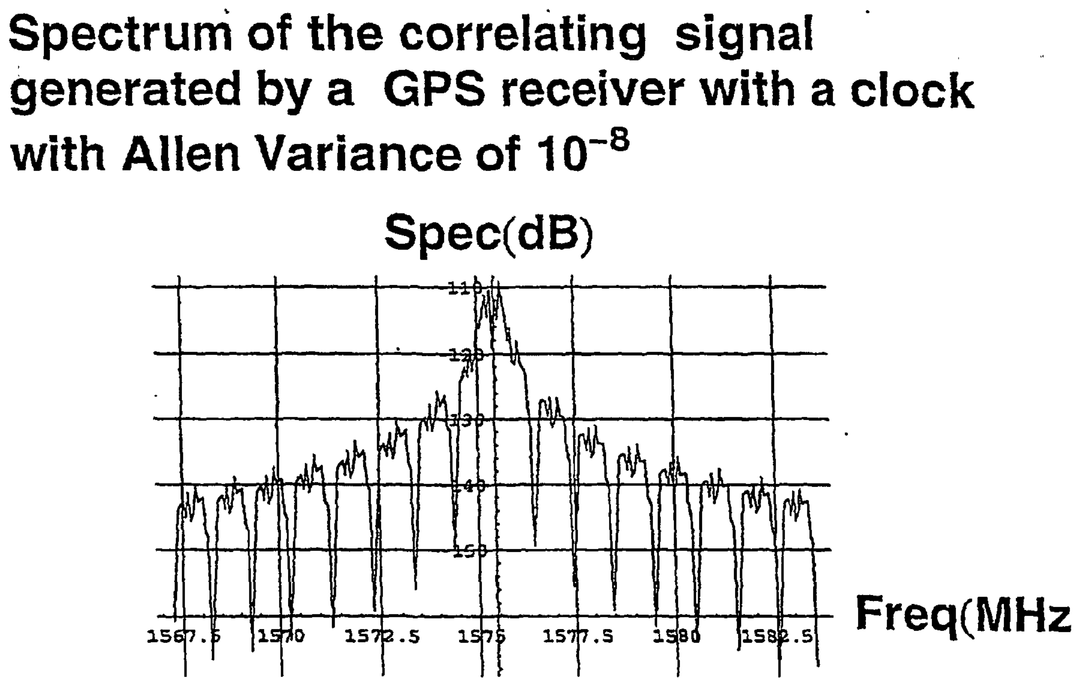


```
- Graphics -

CorrIdeal[τ_] = (IdealFreqDelayVec[τ]).Reverse[IdealFreq] δf;
```

$$\left(\text{corI} = \text{Table}\left[\frac{\text{CorrIdeal}[\tau]}{\text{CorrIdeal}[0]\ //\ \text{Re}}\ //\ \text{Re},\ \text{Evaluate}\left[\left\{\tau,\ \frac{-T}{2},\ \frac{T}{2},\ \frac{T}{20}\right\}\ /.\ \text{GPSSystem}\right]\right]\right)\ //$$

ListPlot;

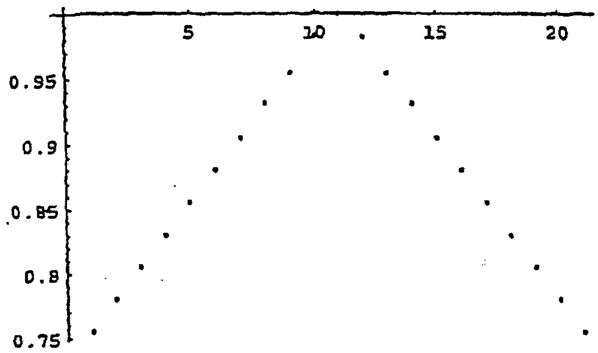

Max[corI // Re]

$9.71328 \times 10^{-7}$

Corr1[τ_] = (ReceivedSpec1 DelayVec[τ]).Reverse[IdealFreq] δf;

$$\left(\text{cor1} = \text{Table}\left[\frac{\text{Corr1}[\tau]}{\text{CorrIdeal}[0]\ //\ \text{Re}}\ //\ \text{Re},\ \text{Evaluate}\left[\left\{\tau,\ \frac{-T}{2},\ \frac{T}{2},\ \frac{T}{20}\right\}\ /.\ \text{GPSSystem}\right]\right]\right)\ //$$

ListPlot;

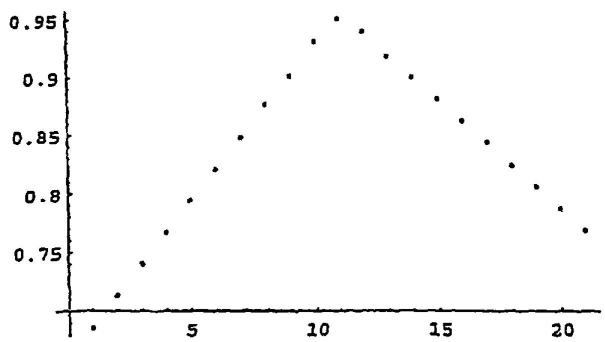

Max[cor1 // Re]

$9.23807 \times 10^{-7}$

ReceivedSpec2 = ReceivedSpec[3 $10^{-8}$]

ReceivedSpec3 = ReceivedSpec[ $10^{-7}$]

Save["IdealFreqVal.m", {ReceivedSpec1, ReceivedSpec2, ReceivedSpec3}]

Corr2[τ_] = (ReceivedSpec2 DelayVec[τ]).Reverse[IdealFreq] δf;

```
(cor2 = Table[Corr2[τ]/(CorrIdeal[0] // Re) // Re, Evaluate[{τ, -T/2, T/2, T/20} /. GPSSystem]]) //
  ListPlot;
```

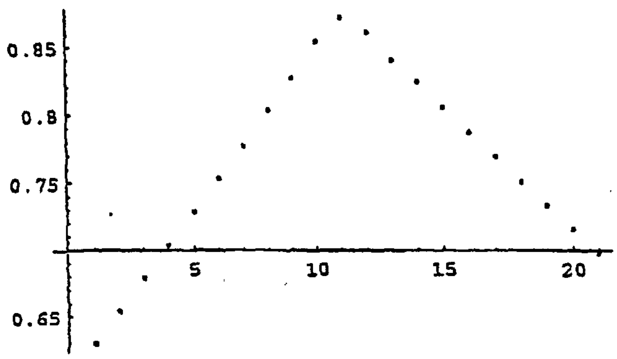


```
Max[cor2 // Re]
```

$8.47201 \times 10^{-7}$

```
Corr3[τ_] = (ReceivedSpec3 DelayVec[τ]).Reverse[IdealFreq] δf;

(cor3 = Table[Corr3[τ]/(CorrIdeal[0] // Re) // Re, Evaluate[{τ, -T/2, T/2, T/20} /. GPSSystem]]) //
  ListPlot;
```

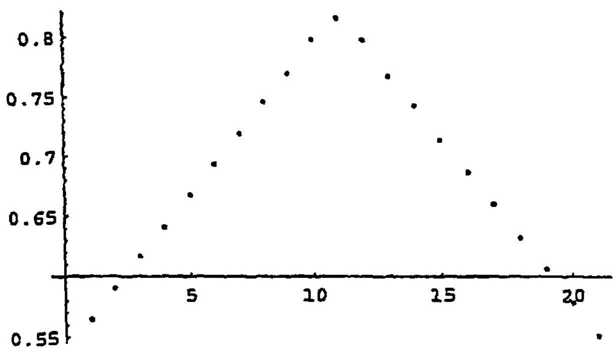


```
Max[cor3 // Re]
```

$7.92443 \times 10^{-7}$

```
gra1 = ListPlot[{Table[τ // Re, Evaluate[{τ, -1/2, 1/2, 1/20}]], corI} // Transpose,
  PlotJoined → True]
```

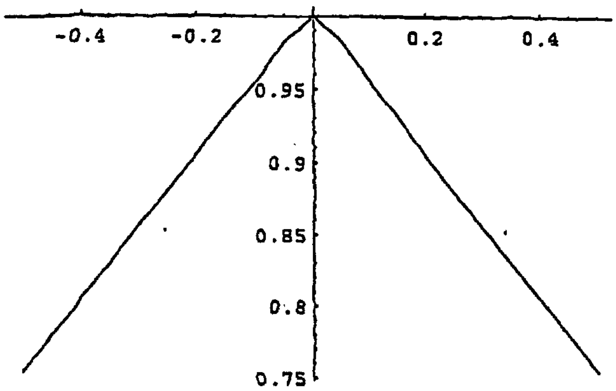


- Graphics -

```
gra2 = ListPlot[{Table[τ // Re, Evaluate[{τ, -1/2, 1/2, 1/20}]], cor1} // Transpose,
  PlotJoined → True]
```

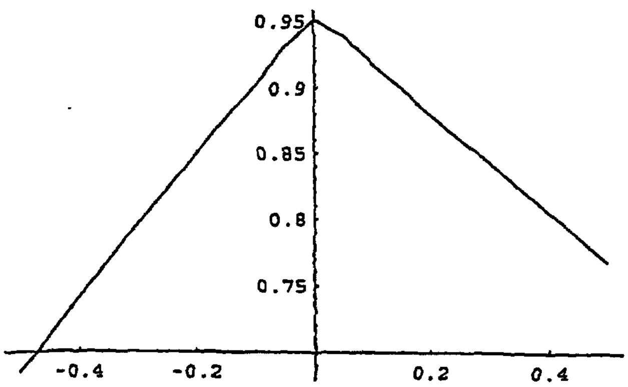


- Graphics -

```
Show[%, %%]
```

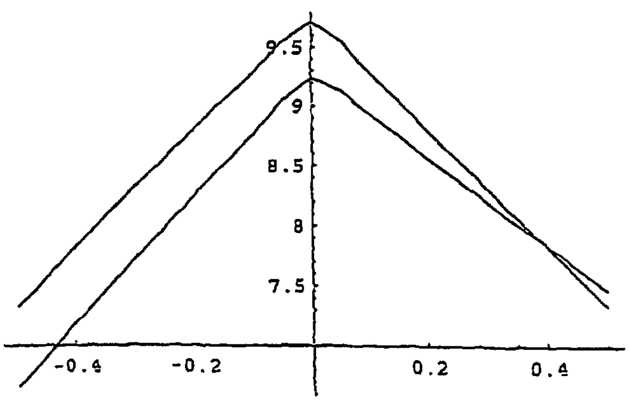


- Graphics -

```
gra3 = ListPlot[{Table[τ // Re, Evaluate[{τ, -1/2, 1/2, 1/20}]], cor2} // Transpose,
  PlotJoined → True]
```

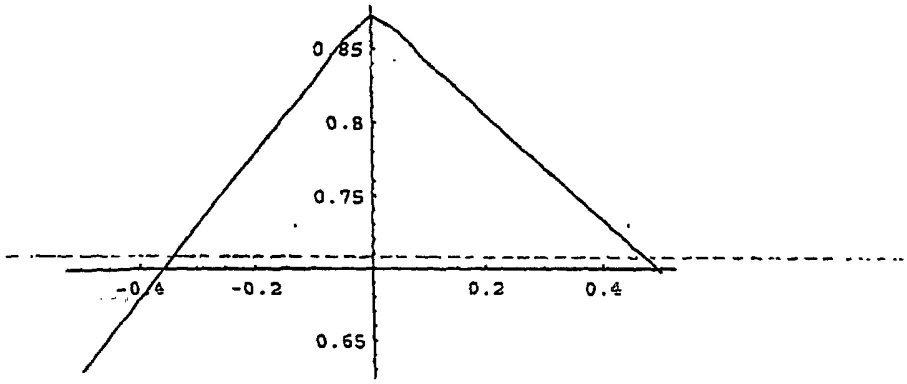


- Graphics -

```
gra4 = ListPlot[{Table[τ // Re, Evaluate[{τ, -1/2, 1/2, 1/20}]], cor3} // Transpose,
  PlotJoined → True]
```

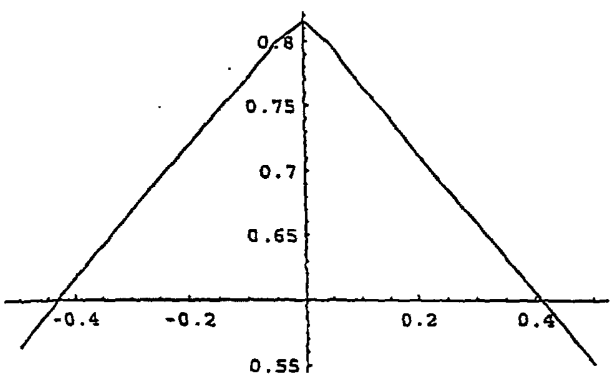


- Graphics -

```
Show[gra1, gra2, gra3, gra4,
 PlotLabel → StyleForm[StringJoin["\n\n Comparing the  Ideal correlation\n
      against the correlation  in a GPS receiver \n using clocks with
      Allen Variances of\n 10^-8, 3 10^-8 , 10^-7  respectively \n\n\n"],
   FontFamily → "Arial", FontSize → "24", FontWeight → "Bold"],
 AxesLabel → {StyleForm["Delay(T)", FontFamily → "Arial",
    FontSize → "24", FontWeight → "Bold"] , StyleForm["Corr(%)",
    FontFamily → "Arial", FontSize → "24", FontWeight → "Bold"]},
 AxesOrigin → {0, 0.5}, GridLines → Automatic]
```

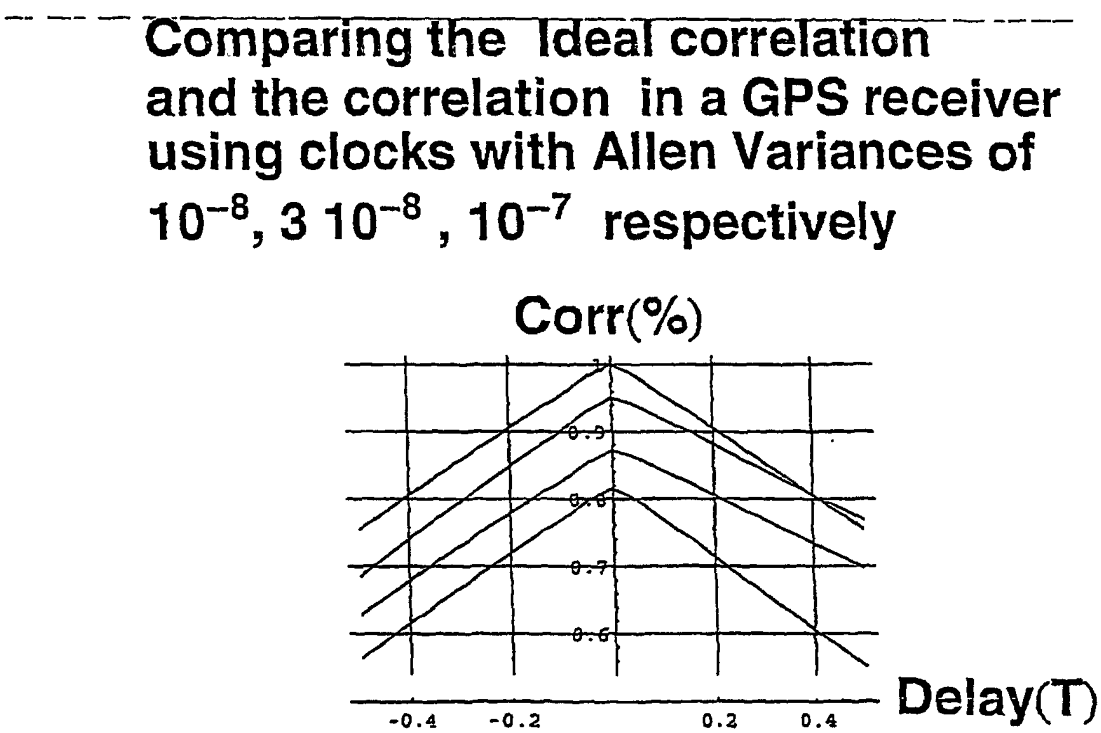


- Graphics -

```
Show[gra1, gra2, gra3, gra4,
 PlotLabel → StyleForm[StringJoin["\n\nRelative Correlation  in GPS receiver
     \n using  Ideal Clock  and Clocks with\n Allen Variances of 10^-8,
     3 10^-8 , 10^-7 with \n respect to Maximum Ideal Correlation \n\n\n"],
   FontFamily → "Arial", FontSize → "24", FontWeight → "Bold"],
 AxesLabel → {StyleForm["Delay(T)", FontFamily → "Arial",
    FontSize → "24", FontWeight → "Bold"] , StyleForm["Corr(%)",
    FontFamily → "Arial", FontSize → "24", FontWeight → "Bold"]},
 AxesOrigin → {0, 0.5}, GridLines → Automatic]
```

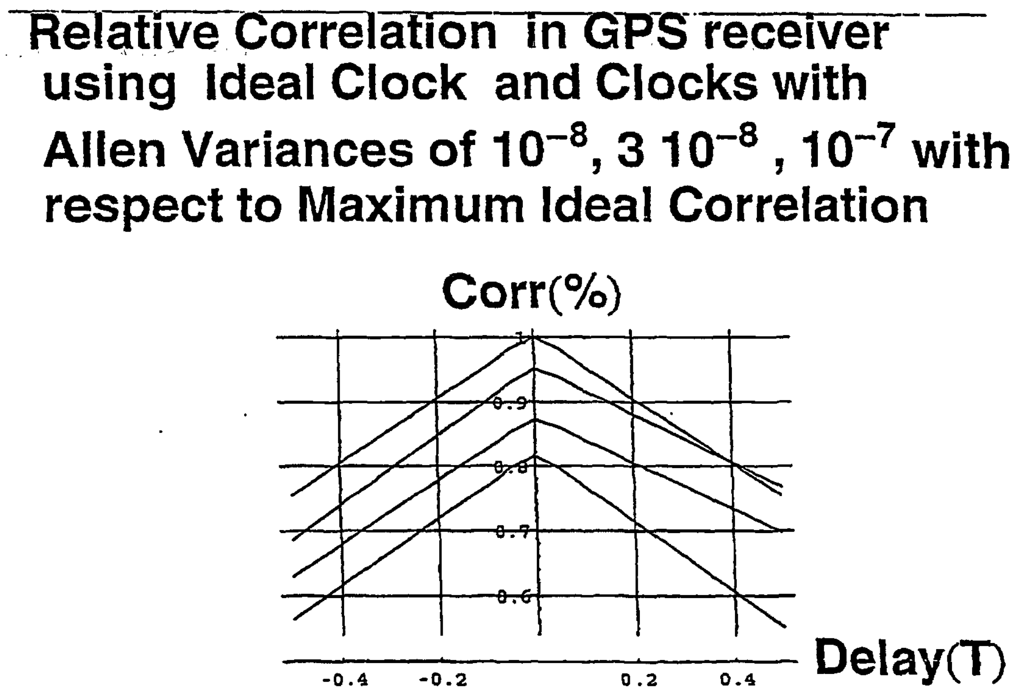


```
- Graphics -

FilteredDataPos[filename_] :=
  Module[{x1, x2, x3, x4},
   x1 = Import[filename, "Table"];
   x2 = Drop[x1, 8] // Transpose // Rest;
   x3 = N[2 Pi/360];
   x4 = {x2 [[1]] 10^6, x2[[4]] (Cos[x3 x2[[5]] ] + I Sin[x3 x2[[5]] ] )} ];
```

```
FilteredDataNeg[filename_] :=
  Module[{x1, x2, x3, x4},
   x1 = Import[filename, "Table"];
   x2 = Drop[x1, 8] // Transpose // Rest;
   x3 = N[2 Pi/360];
   x4 = {-(x2 [[1]] 10^6), x2[[6]] (Cos[x3 x2[[7]]] + I Sin[x3 x2[[7]]])}];

Import["Noel.txt", "Table"] // Take[#, 8] &

{{!, GPS, Fujitsu, SAW}, {!, S2P, Parameter, Extraction, by, Grabber, 488},
 {!, C:\GRAB488\output.S2P}, {!, Extraction, at, 11:53:57, On, 07/07/00},
 {!, 100MHz, Span}, {S11, S21, S12, S22},
 {FREQ, mag, pha, mag, pha, mag, pha, mag, pha}, {#, MHZ, S, MA, R, 50}}

MeasuredDataPos = FilteredDataPos["Noel.txt"];

MeasuredDataNeg = FilteredDataNeg["Noel.txt"];

x1 = MeasuredDataPos // Transpose;
x2 = Map[{#[[1]] 10^-9, 20 Log[10, Abs[#[[2]]]]} &, x1];
x3 = ListPlot[x2, PlotJoined → True,
  PlotLabel → StyleForm[StringJoin["Filter GPS,Fujitsu, SAW ",
     ToString[(f0 /. GPSSystem) 10^-9], "GHz\n\n"],
    FontFamily → "Arial", FontWeight → "Bold"], AxesLabel → {"GHz", "dB"},
  AxesOrigin → {1.57, 0}, GridLines → Automatic]
```

Filter GPS,Fujitsu, SAW 1.57542GHz

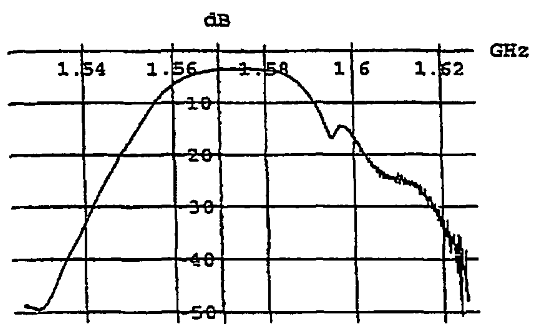


- Graphics -

```
Show[x3, PlotLabel → StyleForm[StringJoin["\n\n",
    "Filter for GPS\nFujitsu, SAW ", ToString[(f0 /. GPSSystem) 10^-9], "GHz\n\n"],
   FontFamily → "Arial", FontSize → "24", FontWeight → "Bold"], AxesLabel →
  {StyleForm["GHz", FontFamily → "Arial", FontSize → "24", FontWeight → "Bold"] ,
   StyleForm["dB", FontFamily → "Arial", FontSize → "24", FontWeight → "Bold"]},
 AxesOrigin → {1.57, 0}, GridLines → Automatic]
```

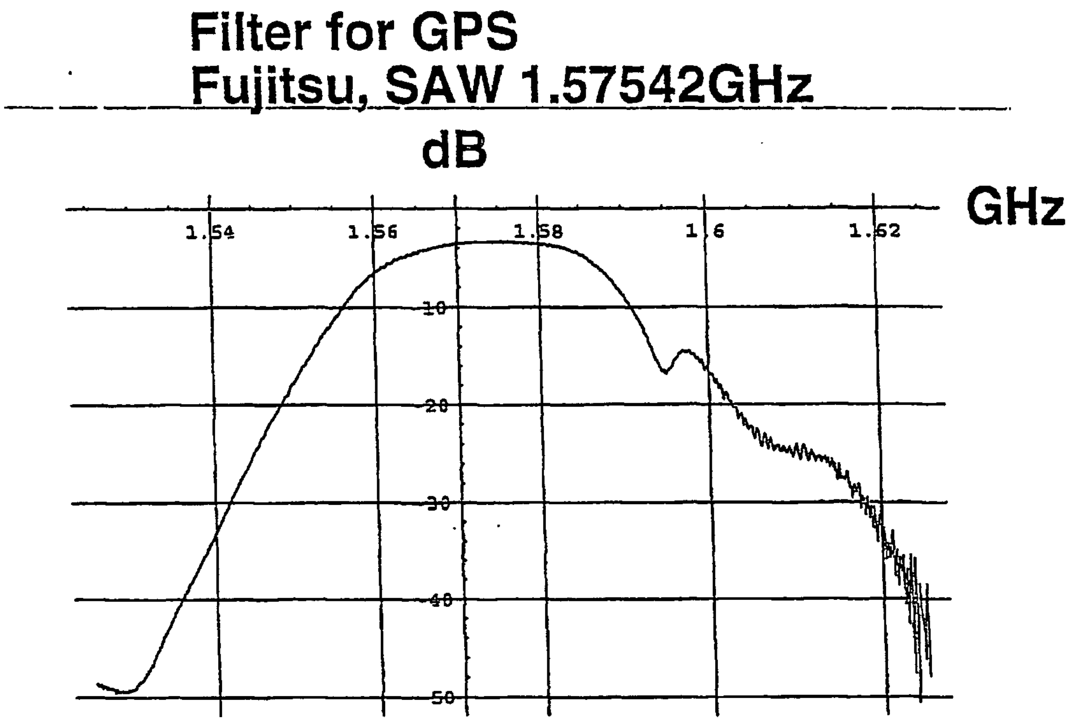


```
- Graphics -
```

```
x1 = MeasuredDataNeg // Transpose;
x2 = Map[{#[[1]] 10^-9, 20 Log[10, Abs[#[[2]]]]} &, x1];
x3 = ListPlot[x2, PlotJoined → True,
  PlotLabel → StyleForm[StringJoin["Filter GPS,Fujitsu, SAW ",
     ToString[(f0 /. GPSSystem) 10^-9], "GHz\n\n"],
    FontFamily → "Arial", FontWeight → "Bold"], AxesLabel → {"GHz", "dB"},
  AxesOrigin → {-1.57, 0}, GridLines → Automatic]
```

Filter GPS,Fujitsu, SAW 1.57542GHz

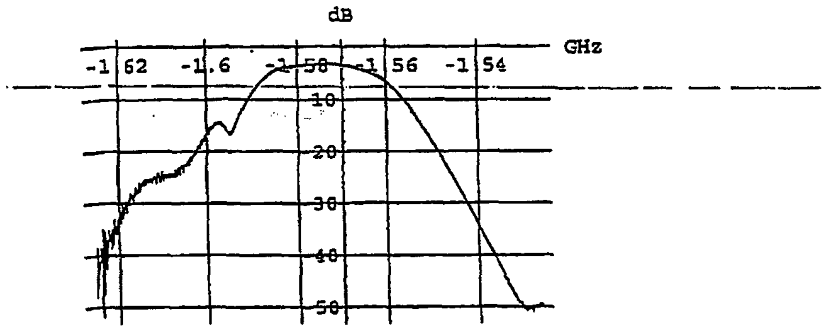


```
- Graphics -

measured[f_] /; f ≥ 0  := Evaluate[Interpolation[MeasuredDataPos // Transpose] [f] ]

measured[f_] /; Not[f ≥ 0]  :=
 Evaluate[Interpolation[MeasuredDataNeg // Transpose] [f] ]

ScalePos = Table[measured[(f0 /. GPSSystem) + f] // Abs, {f, -10000, 10000, 1000}]

{0.682667, 0.682659, 0.682651, 0.682641, 0.682632, 0.682621, 0.68261,
 0.682599, 0.682586, 0.682574, 0.68256, 0.682537, 0.682514, 0.68249,
 0.682465, 0.68244, 0.682414, 0.682388, 0.682361, 0.682333, 0.682305}

ScaleNeg = Table[measured[(-f0 /. GPSSystem) + f] // Abs, {f, -10000, 10000, 1000}]

{0.688542, 0.688575, 0.688606, 0.688637, 0.688668, 0.688698, 0.688728,
 0.688757, 0.688785, 0.688813, 0.68884, 0.688857, 0.688874, 0.68889,
 0.688906, 0.688921, 0.688935, 0.688949, 0.688962, 0.688975, 0.688987}
```

$$\text{GainCompensation = Join[ScalePos, ScaleNeg] // } \frac{\text{Apply[Plus, \#]}}{\text{Length[\#]}} \ \&$$

```
0.685666

//
```

```
Filter := Module[{x1, x2, x3},
  x1 = Table[measured[f]/GainCompensation,
     Evaluate[{f, (-16/(2 T) - f0 /. GPSSystem) + δf/2, (16/(2 T) - f0) /. GPSSystem, δf}]];
  x2 = Table[measured[f]/GainCompensation, Evaluate[
      {f, (-16/(2 T) + f0 /. GPSSystem) + δf/2, (16/(2 T) + f0) /. GPSSystem, δf}]];
  Join[
   x1,
   x2]];

scale = Table[f, Evaluate[{f, (-16/(2 Tc) /. GPSSystem) + δf/2, 16/(2 Tc) /. GPSSystem, δf}]];

ListPlot[{scale 10^-6, 20 Log[10, Abs[fil]]} // Transpose, PlotJoined → True,
  PlotLabel → StyleForm[StringJoin["Filter GPS,Fujitsu, SAW about\n",
    ToString[(f0 /. GPSSystem) 10^-9], "GHz\n\n"], FontFamily → "Arial",
   FontWeight → "Bold"], AxesLabel → {"MHz", "dB"}, GridLines → Automatic]
```

**Filter GPS,Fujitsu, SAW about**
**1.57542GHz**

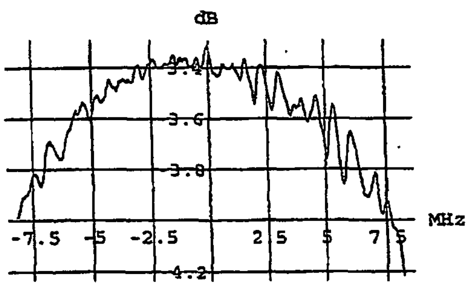


- Graphics -

```
CorrFilIdeal[τ_] = (IdealFreq Filter DelayVec[τ]).Reverse[IdealFreq] δf;
```

$$\left(\text{corFilI} = \text{Table}\left[\frac{\text{CorrFilIdeal}[\tau]}{\text{CorrIdeal}[0]\ //\ \text{Re}}\ //\ \text{Re},\ \text{Evaluate}\left[\left\{\tau,\ \frac{-T}{2},\ \frac{T}{2},\ \frac{T}{20}\right\}\ /.\ \text{GPSSystem}\right]\right]\right)\ //\ \text{ListPlot}[\#,\ \text{PlotJoined} \to \text{True}]\ \&;$$

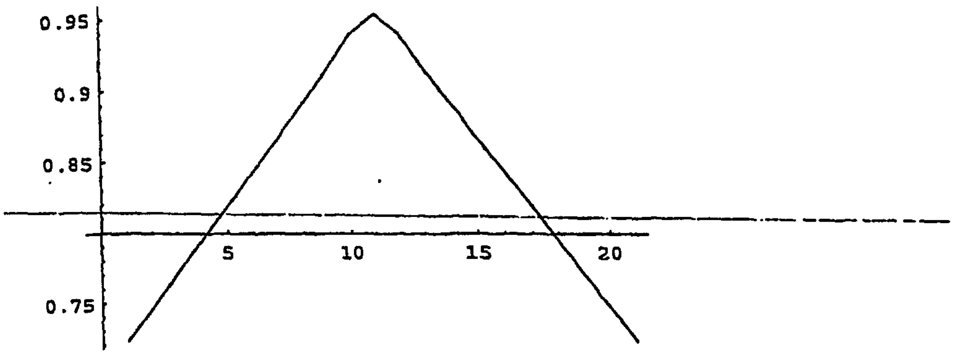


$$\left(\text{corI} = \text{Table}\left[\frac{\text{CorrIdeal}[\tau]}{\text{CorrIdeal}[0]\ //\ \text{Re}}\ //\ \text{Re},\ \text{Evaluate}\left[\left\{\tau,\ \frac{-T}{2},\ \frac{T}{2},\ \frac{T}{20}\right\}\ /.\ \text{GPSSystem}\right]\right]\right)\ //\ \text{ListPlot}[\#,\ \text{PlotJoined} \to \text{True}]\ \&;$$

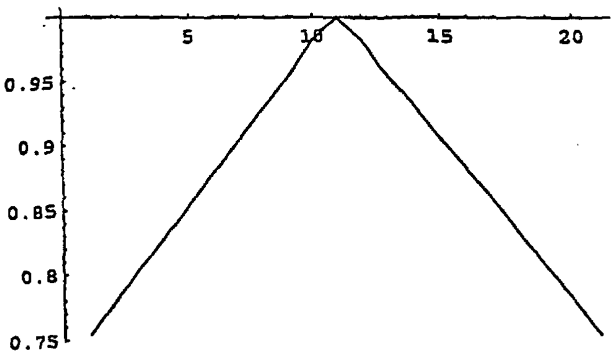


$$\text{gra5} = \text{ListPlot}\left[\left\{\text{Table}\left[\tau\ //\ \text{Re},\ \text{Evaluate}\left[\left\{\tau,\ \frac{-1}{2},\ \frac{1}{2},\ \frac{1}{20}\right\}\right]\right],\ \text{corFilI}\right\}\ //\ \text{Transpose},\ \text{PlotJoined} \to \text{True}\right]$$

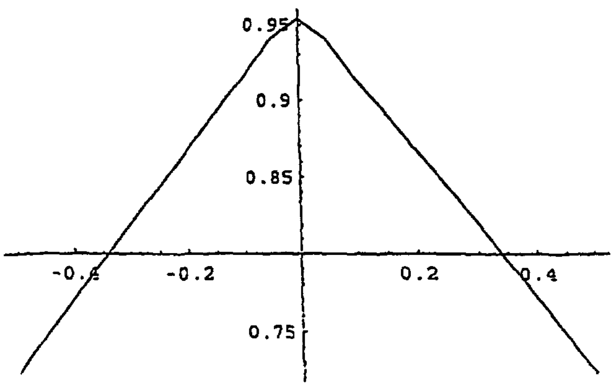


- Graphics -

```
Show[gra1, gra5,
 PlotLabel → StyleForm[StringJoin["\n\n  Comparing the Ideal Correlation against
      the\n correlation  with the Saw filter   in GPS receiver  \n\n\n"],
   FontFamily → "Arial", FontSize → "24", FontWeight → "Bold"],
 AxesLabel → {StyleForm["Delay (T) ", FontFamily → "Arial",
    FontSize → "24", FontWeight → "Bold"] , StyleForm["Corr (%)",
    FontFamily → "Arial", FontSize → "24", FontWeight → "Bold"]},
 AxesOrigin → {0, 0.75}, GridLines → Automatic]
```

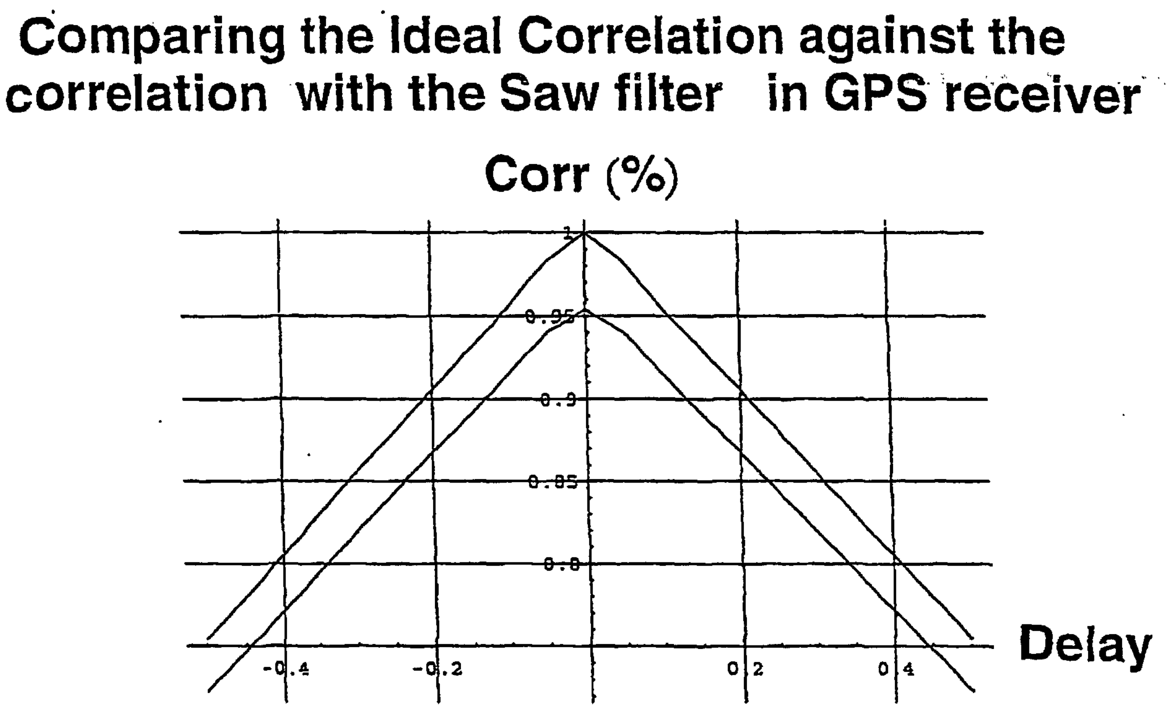


```
- Graphics -

CorrFil1[τ_] = (ReceivedSpec1 Filter DelayVec[τ]).Reverse[IdealFreq] δf;
```

```
(corFil1 = Table[CorrFil1[τ] / (CorrIdeal[0] // Re) // Re,
    Evaluate[{τ, -T/2, T/2, T/20} /. GPSSystem]]) // ListPlot[#, PlotJoined → True] &;
```

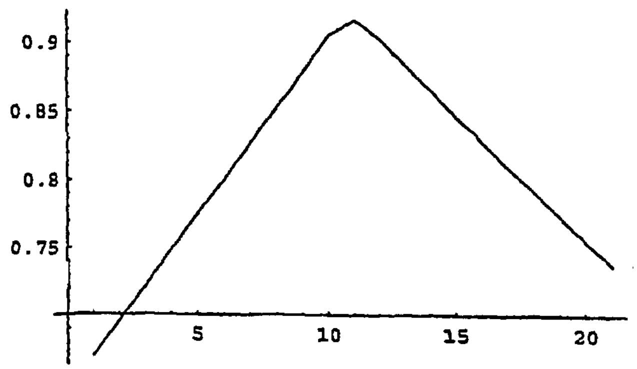


```
gra6 = ListPlot[{Table[τ // Re, Evaluate[{τ, -1/2, 1/2, 1/20}]], corFil1} // Transpose,
  PlotJoined → True]
```

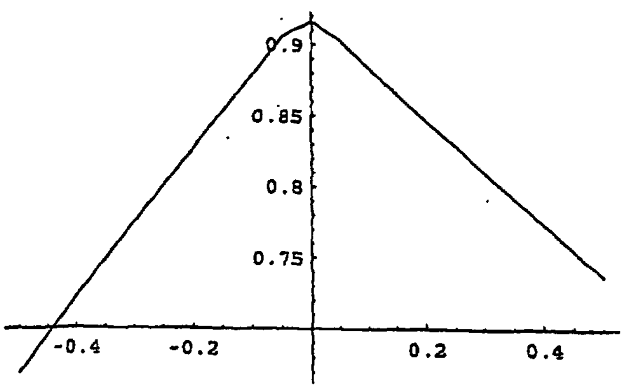


- Graphics -

```
Show[gra1, gra6,
 PlotLabel → StyleForm[StringJoin["\n\n  Comparing the Ideal Correlation
      with the\n combined  effect of Saw filter and  clock\n with
      an Allen Variance of 10^-8 \n in a GPS receiver  \n\n\n"],
   FontFamily → "Arial", FontSize → "24", FontWeight → "Bold"],
 AxesLabel → {StyleForm["Delay (T) ", FontFamily → "Arial",
    FontSize → "24", FontWeight → "Bold"] , StyleForm["Corr (%)",
    FontFamily → "Arial", FontSize → "24", FontWeight → "Bold"]},
 AxesOrigin → {0, 0.75}, GridLines → Automatic]
```

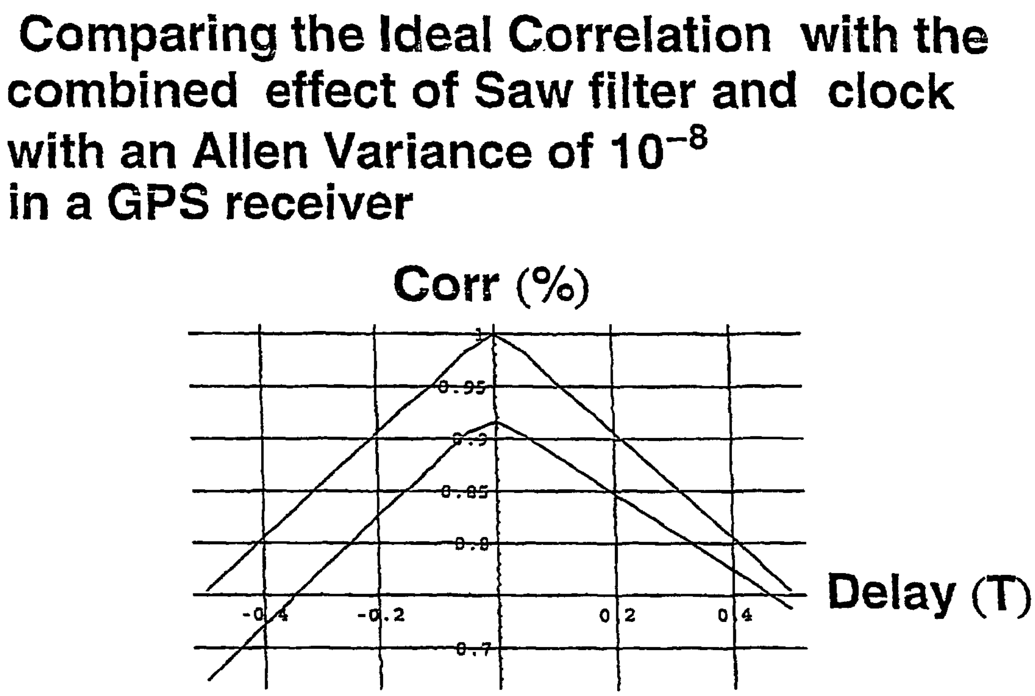


- Graphics -

```
Save["GraphsSynchronisation'", {gra1, gra2, gra3, gra4, gra5, gra6}]
```

**Claims**

1. A method of testing a signal processing component of a device operating in a spread spectrum system in accordance with a predetermined modulation scheme, the method comprising:

   providing an input signal;
   generating a comparison output signal modulated in accordance with the predetermined modulation scheme from the input signal;
   generating a modified output signal modulated in accordance with the predetermined modulation scheme and modified such that the difference between the modified output signal and the comparison output signal is attributable to the signal processing operation performed by the device under test;
   correlating the modified output signal operated on by the device under test with the modulated comparison output signal to provide a measure of the degradation on the signal of the component under test.

2. A method of testing a signal processing component according to claim 1, wherein the comparison output signal is generated using an ideal clock.

3. A method of testing a signal processing component according to claim 1 or claim 2, wherein the modified output signal is the output signal modulated under the control of the ideal clock.

4. A method of testing a signal processing component according to any preceding claim, wherein the modified signal is the modulated comparison signal subsequently operated on by the component under test.

5. A method of testing a signal processing component according to any one of claims 1 to 3, wherein the modified signal is generated from an independent modulation of the input signal.

6. A method of testing a signal processing component according to any preceding claim, wherein the measure comprises the result of the correlation compared with the self correlation of the comparison signal.

7. A method of testing a signal processing component according to any preceding claim wherein the input signal is a data string.

8. A method of testing a signal processing component according to any preceding claim wherein the input signal is a synchronisation frame.

9. A method of testing a signal processing component according to any preceding claim wherein the component is a filter.

10. A method of testing a signal processing component according to any one of claims 1 to 8 wherein the component is an amplifier.

11. A method of testing a signal processing component according to any one of claims 1 to 8 wherein the amplifier is a low noise amplifier.

12. A method of testing a signal processing component according to any one of claims 1 to 8 wherein the component is a mixer.

13. A method of testing a signal processing component according to any one of claims 1 to 8 wherein the component comprises a timing element.

14. A method of testing a signal processing component according to claim 13 wherein the timing element comprises a clock.

15. A method of testing a signal processing component according to claim 13 wherein the timing element comprises an automatic frequency control algorithm.

16. A method of testing a signal processing component according to claim 13 wherein the timing element comprises a synchronisation algorithm.

17. A method of testing a signal processing component according to any preceding claim wherein the method further comprises the step of measuring the affect of the component under test on the power transmitted.

18. A method of testing a signal processing component according to claim 17 wherein the measure is the ratio between the output of the correlation and the power transmitted.

19. A method of testing a signal processing component according to claim 17 or 18 wherein the power transmitted is calculated by correlating the output of the component under test operating on white noise with itself.

20. A method of testing a signal processing component according to claim 19 wherein a normalised figure is produced by using white noise with a unit power spectral density.

21. A method of testing a signal processing component according to any preceding claim wherein if the result of the correlation is an imaginary number the measure is formed from the complex conjugate of the correlation.

22. Apparatus for testing a signal processing component of a device operating in a spread spectrum system in accordance with a predetermined modulation scheme, comprising:

means for providing an input signal;
means for generating a comparison output signal modulated in accordance with the predetermined modulation scheme from the input signal;
means for generating a modified output signal modulated in accordance with the predetermined modulation scheme such that the difference between the modified output signal and the comparison output signal is attributable to the signal processing operation performed by the component under test;
means for correlating the modified output signal operated on by the device under test with the modulated comparison output signal to provide a measure of the degradation on the signal of the component under test.

**23.** Means for testing a signal processing component according to claim 22, wherein the modulation signal and comparison signal are generated at the same time.

**24.** Apparatus for testing a signal processing component according to claim 22, wherein the modulation signal and comparison signal are generated at different times.

**25.** A method for testing a signal processing component of a device operating in a spread spectrum system in accordance with a predetermined modulation scheme, the method comprising:

providing an input signal;
generating an output signal modulated in accordance with the predetermined modulation scheme of known distortion from the input signal;
generating an output signal modulated in accordance with the predetermined modulation scheme and operated on by the device under test from the input signal;
correlating the modulated output signal operated on by the device under test with the modulated output signal of known distortion to provide a measure of the degradation on the signal of the component under test.

**26.** A method according to claim 25 wherein the step of generating an output signal of known distortion comprises modulating the input signal under the control of a clock of known distortion.

**27.** A method according to claim 25 or 26 wherein the step of generating an output signal operated on by the device under test comprises modulating the input signal under the control of a clock under test.

**28.** A method according to claim 25, 26, or 27 wherein the step of generating an output signal operated on by the device under test comprises modulating the input signal under the control of the clock and processing the signal with the component under test.

## Patentansprüche

**1.** Verfahren zum Prüfen einer Signalverarbeitungskomponente für eine Vorrichtung, die in einem Spreizspektrumsystem gemäß einem vorbestimmten Modulationsschema arbeitet, mit den Schritten:

Bereitstellen eines Eingabesignals;
Erzeugen eines Vergleichsausgabesignals, das gemäß dem vorbestimmten Modulationsschema moduliert ist, aus dem Eingabesignal;
Erzeugen eines modifizierten Ausgabesignals, das gemäß dem vorbestimmten Modulationsschema moduliert und derart modifiziert ist, dass die Abweichung zwischen dem modifizierten Ausgabesignal und dem Vergleichsausgabesignal der von der Vorrichtung in Prüfung durchgeführten Signalverarbeitungsoperation zuordenbar ist;
Korrelieren des modifizierten Ausgabesignals, das von der Vorrichtung in Prüfung bearbeitet ist, mit dem modulierten Vergleichsausgabesignal, um ein Maß der Verschlechterung bezüglich des Signals der Komponente in Prüfung bereitzustellen.

**2.** Verfahren zum Prüfen einer Signalverarbeitungskomponente gemäß Anspruch 1, bei dem das Vergleichsausgabesignal unter Verwendung eines idealen Takts erzeugt wird.

3. Verfahren zum Prüfen einer Signalverarbeitungskomponente gemäß Anspruch 1 oder Anspruch 2, bei dem das modifizierte Ausgabesignal das Ausgabesignal ist, das unter der Steuerung des idealen Takts moduliert ist.

4. Verfahren zum Prüfen einer Signalverarbeitungskomponente gemäß einem der vorhergehenden Ansprüche, bei dem das modifizierte Signal das modulierte Vergleichssignal ist, das anschließend von der Komponente in Prüfung bearbeitet ist.

5. Verfahren zum Prüfen einer Signalverarbeitungskomponente gemäß einem der Ansprüche 1 bis 3, bei dem das modifizierte Signal aus einer unabhängigen Modulation des Eingabesignals erzeugt wird.

6. Verfahren zum Prüfen einer Signalverarbeitungskomponente gemäß einem der vorhergehenden Ansprüche, bei dem das Maß das Ergebnis der mit der Autokorrelation des Vergleichssignals verglichenen Korrelation aufweist.

7. Verfahren zum Prüfen einer Signalverarbeitungskomponente gemäß einem der vorhergehenden Ansprüche, bei dem das Eingabesignal eine Datenfolge ist.

8. Verfahren zum Prüfen einer Signalverarbeitungskomponente gemäß einem der vorhergehenden Ansprüche, bei dem das Eingabesignal ein Synchronisationsrahmen ist.

9. Verfahren zum Prüfen einer Signalverarbeitungskomponente gemäß einem der vorhergehenden Ansprüche, bei dem die Komponente ein Filter ist.

10. Verfahren zum Prüfen einer Signalverarbeitungskomponente gemäß einem der Ansprüche 1 bis 8, bei dem die Komponente ein Verstärker ist.

11. Verfahren zu Prüfen einer Signalverarbeitungskomponente gemäß einem der Ansprüche 1 bis 8, bei dem der Verstärker ein rauscharmer Verstärker ist.

12. Verfahren zum Prüfen einer Signalverarbeitungskomponente gemäß einem der Ansprüche 1 bis 8, bei dem die Komponente ein Mischer ist.

13. Verfahren zum Prüfen einer Signalverarbeitungskomponente gemäß einem der Ansprüche 1 bis 8, bei dem die Komponente ein Zeitglied aufweist.

14. Verfahren zum Prüfen einer Signalverarbeitungskomponente gemäß Anspruch 13, bei dem das Zeitglied einen Takt aufweist.

15. Verfahren zum Prüfen eines Signalverarbeitungskomponente gemäß Anspruch 13, bei dem das Zeitglied einen automatischen Frequenzregelungsalgorithmus aufweist.

16. Verfahren zum Prüfen einer Signalverarbeitungskomponente gemäß Anspruch 13, bei dem das Zeitglied einen Synchronisationsalgorithmus aufweist.

17. Verfahren zum Prüfen einer Signalverarbeitungskomponente gemäß einem der vorhergehenden Ansprüche, wobei das Verfahren zusätzlich den Schritt zum Messen des Einflusses der Komponente in Prüfung auf die übertragene Leistung aufweist.

18. Verfahren zum Prüfen einer Signalverarbeitungskomponente gemäß Anspruch 17, bei dem das Maß das Verhältnis zwischen der Ausgabe der Korrelation und der übertragenen Leistung ist.

19. Verfahren zum Prüfen einer Signalverarbeitungskomponente gemäß Anspruch 17 oder 18, bei dem die übertragene Leistung berechnet wird, indem die Ausgabe der Komponente in Prüfung, die auf weißem Rauschen arbeitet, mit sich selbst korreliert wird.

20. Verfahren zum Prüfen einer Signalverarbeitungskomponente gemäß Anspruch 19, bei dem durch Verwendung von weißem Rauschen mit einer Einheitsspektralleistungsdichte eine normalisierte Kennzahl erzeugt wird.

21. Verfahren zum Prüfen einer Signalverarbeitungskomponente gemäß einem der vorhergehenden Ansprüche, bei

dem das Maß, falls das Ergebnis der Korrelation eine imaginäre Zahl ist, aus der Komplexkonjugierten der Korrelation gebildet wird.

**22.** Vorrichtung zur Prüfung einer Signalverarbeitungskomponente für eine Vorrichtung, die in einem Spreizspektrumsystem gemäß einem vorbestimmten Modulationsschema arbeitet, mit:

einer Einrichtung zum Bereitstellen eines Eingabesignals;
einer Einrichtung zum Erzeugen eines Vergleichsausgabesignals, das gemäß dem vorbestimmten Modulationsschema moduliert ist, aus dem Eingabesignal;
einer Einrichtung zum derartigen Erzeugen eines modifizierten Ausgabesignals, das gemäß dem vorbestimmten Modulationsschema moduliert ist, dass die Abweichung zwischen dem modifizierten Ausgabesignal und dem Vergleichsausgabesignal der von der Komponente in Prüfung durchgeführten Signalverarbeitungsoperation zuordenbar ist;
einer Einrichtung zum Korrelieren des modifizierten Ausgabesignals, das von der Vorrichtung in Prüfung bearbeitet ist, mit dem modulierten Vergleichsausgabesignal, um ein Maß der Verschlechterung bezüglich des Signals der Komponente in Prüfung bereitzustellen.

**23.** Vorrichtung zur Prüfung einer Signalverarbeitungskomponente gemäß Anspruch 22, bei der das Modulationssignal und das Vergleichssignal zur gleichen Zeit erzeugt werden.

**24.** Vorrichtung zur Prüfung einer Signalverarbeitungskomponente gemäß Anspruch 22, bei der das Modulationssignal und das Vergleichssignal zu unterschiedlichen Zeiten erzeugt werden.

**25.** Verfahren zum Prüfen einer Signalverarbeitungskomponente für eine Vorrichtung, die in einem Spreizspektrumsystem gemäß einem vorbestimmten Modulationsschema arbeitet, mit den Schritten:

Bereitstellen eines Eingabesignals;
Erzeugen eines Ausgabesignals bekannter Verzerrung, das gemäß dem vorbestimmten Modulationsschema moduliert ist, aus dem Eingabesignal;
Erzeugen eines Ausgabesignals, das gemäß dem vorbestimmten Modulationsschema moduliert und von der Vorrichtung in Prüfung bearbeitet ist, aus dem Eingabesignal;
Korrelieren des modulierten Ausgabesignals, das von der Vorrichtung in Prüfung bearbeitet ist, mit dem modulierten Ausgabesignal bekannter Verzerrung, um ein Maß der Verschlechterung bezüglich des Signals der Komponente in Prüfung bereitzustellen.

**26.** Verfahren gemäß Anspruch 25, bei dem der Schritt zum Erzeugen eines Ausgabesignals bekannter Verzerrung ein Modulieren des Eingabesignals unter der Steuerung eines Takts bekannter Verzerrung aufweist.

**27.** Verfahren gemäß Anspruch 25 oder 26, bei dem der Schritt zum Erzeugen eines Ausgabesignals, das von der Vorrichtung in Prüfung bearbeitet ist, ein Modulieren des Eingabesignals unter der Steuerung eines Takts in Prüfung aufweist.

**28.** Verfahren gemäß Anspruch 25, 26 oder 27, bei dem der Schritt zum Erzeugen eines Ausgabesignals, das von der Vorrichtung in Prüfung bearbeitet ist, ein Modulieren des Eingabesignals unter der Steuerung des Takts und ein Verarbeiten des Signals mit der Komponente in Prüfung aufweist.

## Revendications

**1.** Procédé de test d'un composant de traitement de signaux pour un dispositif opérant dans un système à spectre étalé en conformité avec un schéma de modulation prédéterminé, le procédé comprenant les étapes consistant à :

former un signal d'entrée ;
générer un signal de sortie de comparaison modulé en conformité avec le schéma de modulation prédéterminé depuis le signal d'entrée ;
générer un signal de sortie modifié modulé en conformité avec le schéma de modulation prédéterminé et modifié de sorte que la différence entre le signal de sortie modifié et
le signal de sortie de comparaison est attribuable à l'opération de traitement de signaux effectuée par le dispositif sous test ;
corréler le signal de sortie modifié mis en oeuvre par le dispositif sous test avec le signal de sortie de comparaison modulé pour procurer une mesure de la détérioration du signal du composant sous test.

2. Procédé de test d'un composant de traitement de signaux selon la revendication 1, dans lequel le signal de sortie de comparaison est généré en utilisant une horloge idéale.

3. Procédé de test d'un composant de traitement de signaux selon la revendication 1 ou 2, dans lequel le signal de sortie modifié est le signal de sortie modulé sous la commande de l'horloge idéale.

4. Procédé de test d'un composant de traitement de signaux selon l'une quelconque des revendications précédentes, dans lequel le signal modifié est le signal de comparaison modulé mis en oeuvre par la suite par le composant sous test.

5. Procédé de test d'un composant de traitement de signaux selon l'une quelconque des revendications 1 à 3, dans lequel le signal modifié est généré à partir d'une modulation indépendante du signal d'entrée.

6. Procédé de test d'un composant de traitement de signaux selon l'une quelconque des revendications précédentes, dans lequel la mesure comprend le résultat de la corrélation comparé à l'autocorrélation du signal de comparaison.

7. Procédé de test d'un composant de traitement de signaux selon l'une quelconque des revendications précédentes, dans lequel le signal d'entrée est une chaîne de données.

8. Procédé de test d'un composant de traitement de signaux selon l'une quelconque des revendications précédentes, dans lequel le signal d'entrée est une trame de synchronisation.

9. Procédé de test d'un composant de traitement de signaux selon l'une quelconque des revendications précédentes, dans lequel le composant est un filtre.

10. Procédé de test d'un composant de traitement de signaux selon l'une quelconque des revendications 1 à 8, dans lequel le composant est un amplificateur.

11. Procédé de test d'un composant de traitement de signaux selon l'une quelconque des revendications 1 à 8, dans lequel l'amplificateur est un amplificateur à faible bruit.

12. Procédé de test d'un composant de traitement de signaux selon l'une quelconque des revendications 1 à 8, dans lequel le composant est un mélangeur.

13. Procédé de test d'un composant de traitement de signaux selon l'une quelconque des revendications 1 à 8, dans lequel le composant comprend un élément de cadencement.

14. Procédé de test d'un composant de traitement de signaux selon la revendication 13, dans lequel l'élément de cadencement comprend une horloge.

15. Procédé de test d'un composant de traitement de signaux selon la revendication 13, dans lequel l'élément de cadencement comprend un algorithme de commande automatique de fréquence.

16. Procédé de test d'un composant de traitement de signaux selon la revendication 13, dans lequel l'élément de cadencement comprend un algorithme de synchronisation.

17. Procédé de test d'un composant de traitement de signaux selon l'une quelconque des revendications précédentes, dans lequel le procédé comprend, en outre, l'étape consistant à mesurer l'effet du composant sous test sur l'énergie transmise.

18. Procédé de test d'un composant de traitement de signaux selon la revendication 17, dans lequel la mesure est le rapport entre la sortie de la corrélation et l'énergie transmise.

19. Procédé de test d'un composant de traitement de signaux selon la revendication 17 ou 18, dans lequel l'énergie

transmise est calculée en corrélant la sortie du composant sous test opérant sur du bruit blanc avec lui-même.

**20.** Procédé de test d'un composant de traitement de signaux selon la revendication 19, dans lequel un chiffre normalisé est produit en utilisant le bruit blanc avec une densité spectrale d'énergie unitaire.

**21.** Procédé de test d'un composant de traitement de signaux selon l'une quelconque des revendications précédentes, dans lequel si le résultat de la corrélation est un nombre imaginaire, la mesure est formée à partir de la conjuguée complexe de la corrélation.

**22.** Appareil pour tester un composant de traitement de signaux pour un dispositif opérant dans un système à spectre étalé en conformité avec un schéma de modulation prédéterminé, comprenant :

un moyen pour fournir un signal d'entrée ;
un moyen pour générer un signal de sortie de comparaison modulé en conformité avec le schéma de modulation prédéterminé à partir du signal d'entrée ;
un moyen pour générer un signal de sortie modifié modulé en conformité avec le schéma de modulation prédéterminé de sorte que la différence entre le signal de sortie modifié et
le signal de sortie de comparaison est attribuable à l'opération de traitement de signaux effectuée par le composant sous test ;
un moyen pour corréler le signal de sortie modifié mis en oeuvre par le dispositif sous test avec le signal de sortie de comparaison modulé pour procurer une mesure de la détérioration sur le signal du composant sous test.

**23.** Moyen pour tester un composant de traitement de signaux selon la revendication 22, dans lequel le signal de modulation et le signal de comparaison sont générés au même instant.

**24.** Appareil pour tester un composant de traitement de signaux selon la revendication 22, dans lequel le signal de modulation et le signal de comparaison sont générés à des instants différents.

**25.** Procédé pour tester un composant de traitement de signaux pour un dispositif opérant dans un système à spectre étalé en conformité avec un schéma de modulation prédéterminé, le procédé comprenant les étapes consistant à :

fournir un signal d'entrée ;
générer un signal de sortie modulé en conformité avec le signal de modulation prédéterminé d'une distorsion connue à partir du signal d'entrée ;
générer un signal de sortie modulé en conformité avec le signal de modulation prédéterminé et mis en oeuvre par le dispositif sous test à partir du signal d'entrée ;
corréler un signal de sortie modulé mis en oeuvre par le dispositif sous test avec le signal de sortie modulé d'une distorsion connue pour procurer une mesure de la détérioration sur le signal de composant sous test.

**26.** Procédé selon la revendication 25, dans lequel l'étape consistant à générer un signal de sortie d'une distorsion connue comprend la modulation du signal d'entrée sous la commande d'une horloge d'une distorsion connue.

**27.** Procédé selon la revendication 25 ou 26, dans lequel l'étape consistant à générer un signal de sortie mis en oeuvre par le dispositif sous test comprend la modulation du signal d'entrée sous la commande d'une horloge sous test.

**28.** Procédé selon la revendication 25, 26 ou 27, dans lequel l'étape consistant à générer un signal de sortie mis en oeuvre par le dispositif sous test comprend la modulation du signal d'entrée sous la commande de l'horloge et le traitement du signal avec le composant sous test.

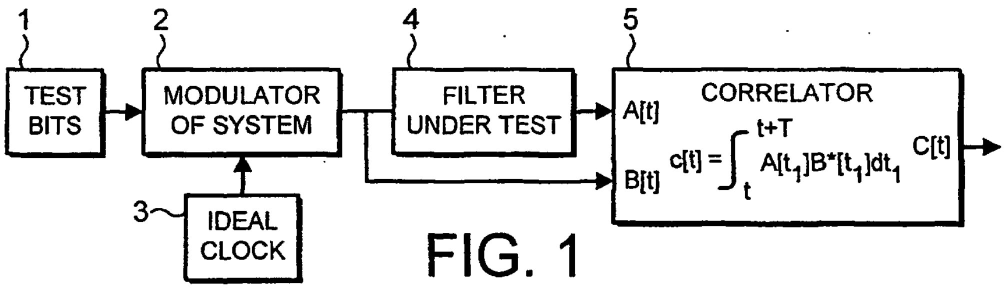


FIG. 1

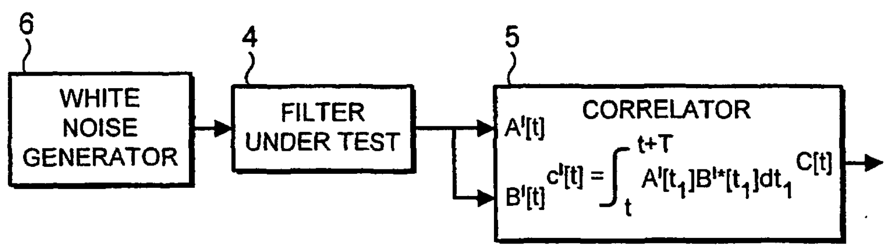


FIG. 2

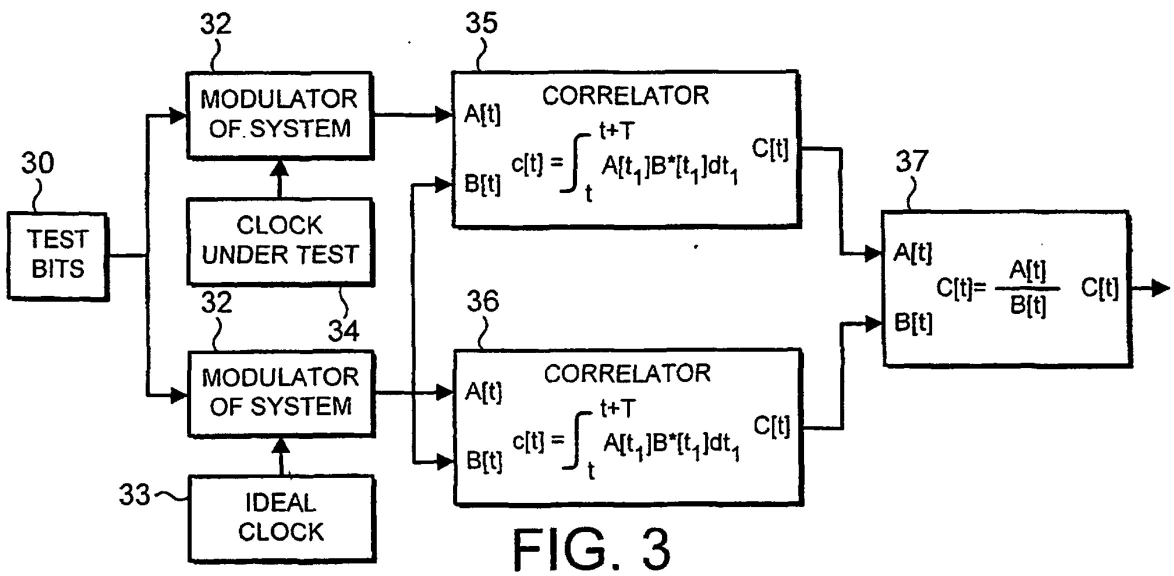


FIG. 3

COMPARING THE IDEAL CORRELATION AGAINST THE CORRELATION OF A REAL FILTER IN GPS RECEIVER

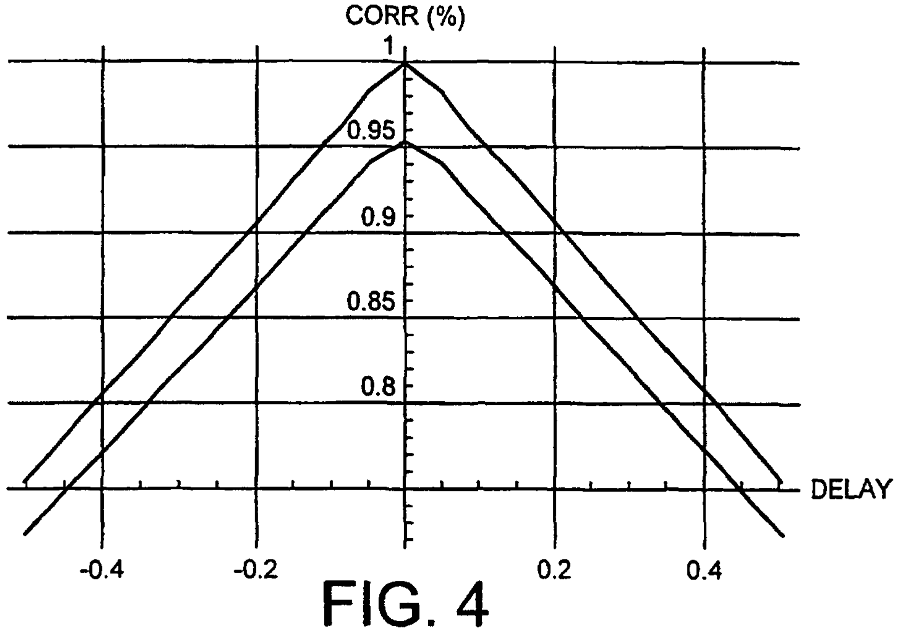


FIG. 4

COMPARING THE IDEAL CORRELATION AND THE CORRELATION IN A GPS RECEIVER USING CLOCKS WITH ALLEN VARIANCES OF $10^{-8}$, 3 $10^{-8}$, $10^{-7}$ RESPECTIVELY

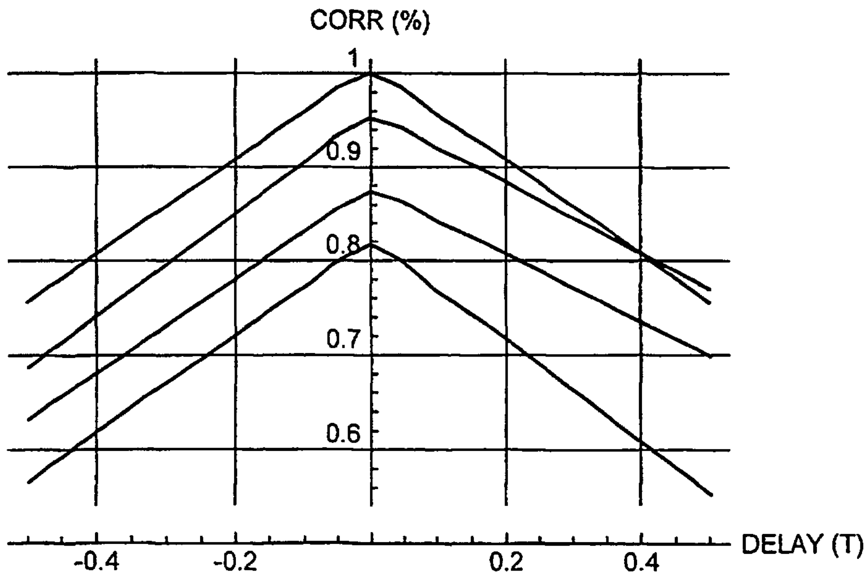


FIG. 5